# EUROPEAN PATENT APPLICATION

(11) **EP 2 916 066 A1**
(43) Date of publication of application: **09.09.2015**
(21) Application number: 14000821.0
(22) Date of filing: 07.03.2014
(51) Int. Cl.: F21V 29/00, F21K 99/00, F21Y 101/02, F21Y 103/02

(54) **Light Emitting Diode (LED) devices with an improved light distribution and an optimized heat distribution**

(71) Applicant: Muessli, Daniel, 8957 Spreitenbach (CH)
(72) Inventor: Muessli, Daniel, 8957 Spreitenbach (CH)
(74) Representative: Schaad, Balass, Menzl & Partner AG

(57) **Abstract**

A first aspect of a Light emitting diode (LED) device (156) according to the present invention comprises a number of LED dies (158) and a thermal conductive cooling and supporting sheet (178) which comprises an upper outer surface (180) and a lower outer surface (182). A number of tongue-like elements (184) are arranged along an edge (186) of the cooling and supporting sheet (178), are spaced apart from each other, are formed integrally with and protruding from the cooling and supporting sheet (178) and comprises a free end region (190). The LED dies (158) are connected with its bottom surfaces (162) to the free end region (190) of the respective tongue-like elements (184). According to the first aspect of the present invention the LED dies (158) are arranged close to the end face (196) and the width (198) of the tongue-like elements (184), measured parallel to the upper outer surface (180) and orthogonally to a longitudinal axis (188) of the tongue-like elements (184), has at most the same dimension as the LED dies (158) measured in the same direction.

## Description

The present invention relates to Light Emitting Diode (LED) devices according to claims 1, 2 and 19.

Light emitting diodes (LEDs) are widely used in many applications due to the advantages such as high luminosity, low operational voltage and power consumption, compatibility with integrated circuits, easy driving, long term reliability and environmental friendliness promoted their wide use as a lighting source.

A LED die is in general fabricated with a semiconductor material of a group III-V compound and is able to generate light, ranging from infrared (IR) to ultraviolet (UV). Since recently, because of the development of the gallium nitride (GaN) blue LEDs or green LEDs, full color diode displays and other applications can be implemented.

The LED die is basically formed with a P-type or N-type epitaxial layer of the group III-V compound and an active layer, i.e. an emitting layer. The efficiency of the LED die depends on the internal quantum efficiency of the active layer and the light extraction efficiency of the LED die.

In general, the light emitted from the LED die radiates from the active layer of the LED die materials in an angle of about 120° to the outer surfaces of the LED die due to the different refractive indices of the LED die materials and the surrounding. Therefore only a small percentage of the photons generated in the active layer of the LED die actually emits from the LED die and radiates to the surrounding. The rest of the photons generated in the LED die are internally reflected and reabsorbed by the LED die material, generating unwanted heat.

A typical setup of a LED device comprises a substrate as a submount, a LED die mounted on the top surface of the substrate and an encapsulation material encapsulating the LED die. On the top surface of the LED die, two contact pads are formed, each being electrically connected to a respective contact pad formed on the top surface of the substrate. The electrical connection between the two contact pads of the LED die and the respective two contact pads of the substrate is made by wire-bonding. The electrical current supplied by wire-bonding to the LED die for operating the LED device generates heat in the LED material.

Therefore, a problem of the typical setup of the LED device is that the heat from the electrical connection and the additional heat from the photons reabsorbed by the LED die results in a relatively high amount of heat inside the LED die materials. This relatively high amount of heat may lead to defects in the LED die materials which further result in a relatively small amount of the light emitted in the LED die material. Consequently the life-time of the typical LED device, especially the aging of the LED die material, is strongly influenced by the additional heat generated in the LED die material.

A further problem of the typical setup of the LED device with the LED die mounted on the top surface of the substrate is due to the fact that only a relatively small amount of light is emitted in the LED die material for the use of the light emission, because the emitted light in the active layer of the LED die material is blocked by the two contact pads which are formed on the top surface of the LED die, by the adhesive or glue between the bottom surface of the LED die and the top surface of the substrate and by the different refractive indices of the substrate and the LED die materials for the emitted light which radiates lateral downwards from the four side surfaces of the LED die to the substrate. The light which is blocked by the adhesive or glue and which is influenced by the refractive index of the substrate has the negative effect that the reflected light in the LED materials is additionally reabsorbed by the LED die materials and thus generates additional heat in the LED die with the negative result of a relatively small amount of the light distribution, a relatively small amount of the efficiency of the LED light emission and a relatively high amount of the heat emission corresponding with a relatively bad heat distribution.

Therefore an object of the present invention is to provide a Light Emitting Diode (LED) device with an improved efficiency of the LED light emission, an improved light distribution, an optimized heat distribution and an improved life time corresponding with a deceleration of the material aging.

In accordance with a first aspect and a second aspect of the present invention there is provided a Light Emitting Diode (LED) device comprising a number of LED dies with a top surface, a bottom surface, a left-side surface, a right-side surface, a front-side surface and a rear-side surface. Two contact pads are formed on the top surface of each LED die and spaced apart from each other. At least the number of LED dies, preferably all LED dies, are electrically connected in series by means of wire bonding. The LED device further comprises a thermal conductive cooling and supporting sheet which comprises an upper outer surface and a lower outer surface. A number of tongue-like elements are arranged along an edge of the cooling and supporting sheet, spaced apart from each other and formed integrally with and protruding from the cooling and supporting sheet. Each of the tongue-like elements defining a longitudinal axis and comprises a free end region. The LED dies being connected with its bottom surfaces to the free end region of the tongue-like elements. The free end regions of the tongue-like elements supporting the LED dies building up a heat zone and the cooling and supporting sheet building up a cooling-down zone. The LED dies being arranged in the free end region of the tongue-like elements either on the upper outer surface of the tongue-like elements according to the first aspect of the present invention or on an end face of the tongue-like elements arranged at least almost orthogonally to the longitudinal axis of the respective tongue-like element according to the second aspect of the present invention.

In case the LED dies being arranged on the upper outer surface of the tongue-like elements according to the first aspect of the present invention, the LED dies being arranged close to the end face and the width of the tongue-like elements, measured parallel to the upper outer surface and orthogonally to the longitudinal axis, has at most the same dimension as the LED dies measured in the same direction. This embodiment comprises an improved light distribution due to the setup of the LED dies with respect to the tongue-like elements in the heat zone. In addition this embodiment comprises an improved cooling effect for the LED dies by an optimized heat transfer from the LED dies in the heat zone to the cooling and supporting sheet as part of the cooling-down zone.

As mentioned in the introduction part of this application the light emitted by the LED dies radiates in an angle of 120° out from the outer surfaces of the LED dies. For the LED device according to the first aspect of the present invention the light which radiates from the LED dies is blocked in the upward direction to the top surface of the LED dies by the respective two contact pads, in the downward direction to the bottom surface of the LED dies by the tongue-like elements and in the lateral downward direction from the rear-side surface of the LED dies also by the tongue-like elements. Thus the front-side surface, the left-side surface and the right-side surface of the LED dies as well as the exposed top surface beside the respective two contact pads is exposed for the light radiation with the positive effect of an improved light distribution and a corresponding homogenous lightning effect for this LED device.

Due to the thermal properties of the tongue-like elements and the cooling and supporting sheet, the heat is transferred from the LED dies, which are arranged on the upper outer surface of the tongue-like elements in the heat zone, to the cooling and supporting sheet in the cooling-down zone. Therefore, an optimized heat distribution for this LED device is possible with the beneficial effect of an increased life time corresponding with a deceleration of the material aging.

In case the LED dies being arranged on the end face of the tongue-like elements according to the second aspect of the present invention, the dimension of the end face comprises preferably at most the same dimension as the bottom surface of the respective LED die. Therefore the dimension of the end face of the tongue-like elements is as big as the dimension of the bottom surface of the LED dies or smaller in size. This embodiment comprises an improved light distribution due to the setup of the LED dies with respect to the tongue-like elements in the heat zone. In addition this embodiment comprises an improved cooling effect for the LED dies by an optimized heat transfer from the LED dies in the heat zone to the cooling and supporting sheet as part of the cooling-down zone.

As mentioned in the introduction part of this application the light emitted by the LED dies radiates in an angle of 120° out from the outer surfaces of the LED dies. For the LED device according to the second aspect of the present invention the light which radiates from the LED dies is blocked in the upward direction to the top surface of the LED dies by the respective two contact pads and in the downward direction to the bottom surface of the LED dies also by the tongue-like elements. Thus the front-side surface, the left-side surface, the rear-side surface and the right-side surface of the LED dies as well as the exposed top surface beside the respective two contact pads is exposed for the light radiation with the result of an improved light distribution and a corresponding homogeneous lightning effect for this LED device.

Due to the thermal properties of the tongue-like elements and the cooling and supporting sheet, the heat is transferred from the LED dies, which are arranged on the end face of the tongue-like elements in the heat zone, to the cooling and supporting sheet in the cooling-down zone. Therefore, an optimized heat distribution for this LED device is possible with the beneficial effect of an increased life time corresponding with a deceleration of the material aging.

In accordance with a third aspect of the present invention there is provided a Light Emitting Diode (LED) device comprising a number of LED dies with a top surface, a bottom surface, a left-side surface, a right-side surface, a front-side surface and a rear-side surface. Two contact pads are formed on the bottom surface of each LED die and spaced apart from each other. The LED device further comprises a number of electrical and thermal conductive cooling and supporting sheets being spaced apart from each other and comprising an upper outer surface and a lower outer surface. Each of the cooling and supporting sheets is formed integrally with and protrudes from a single tongue-like element. Each of the tongue-like elements defines a longitudinal axis and comprises a free end region. Each of the LED dies being connected with its two contact pads to the upper outer surface of the free end region of two adjacent tongue-like elements by means of solder bumps. The free end regions of the respective two adjacent tongue-like elements supporting the respective LED die, building up a heat zone and the cooling and supporting sheets building up a cooling-down zone and the respective LED die being arranged close to an end face of the respective two adjacent tongue-like elements and the respective two tongue-like elements at least almost completely covering the two contact pads and being arranged at least almost in a same distance to each other as the contact pads. This embodiment comprises an improved light distribution due to the setup of the respective LED die with respect to two adjacent tongue-like elements in the heat zone. In addition this embodiment comprises an improved cooling effect for the LED dies by an optimized heat transfer from the LED dies in the heat zone to the two adjacent cooling and supporting sheets as part of the cooling-down zone.

As mentioned in the introduction part of the present invention the light emitted by the LED dies radiates in an angle of 120° out from the surfaces of the LED dies. For the LED device according to the third aspect of the present invention the light which radiates from the LED dies is blocked in the downward direction to the bottom surface of the LED dies by the respective two contact pads and in the lateral downward directions from the left-side surface and right-side surface of the LED dies by the two adjacent tongue-like elements. Thus, the top surface, an exposed region on the bottom surface beside the respective two contact pads, the front-side surface and the rear-side surface of the LED dies are exposed for an about 360° light distribution with the positive effect of an improved light distribution and a corresponding homogenous lightning effect for this LED device similar to conventional light bulbs.

Due to the thermal properties of the two adjacent tongue-like elements and two adjacent cooling and supporting sheets the heat is transferred from the respective LED die, which is arranged in the end regions of the two adjacent tongue-like elements in the heat zone, to the two adjacent cooling and supporting sheets in the cooling-down zone. Therefore, an optimized heat distribution for this LED device is possible with the beneficial effect of an increased life time corresponding with a deceleration of the material aging.

According to a preferred embodiment, one contact pad of the respective LED die is arranged adjacent to the left-side surface and the other contact pad of the respective LED die is arranged adjacent to the right-side surface of the respective LED die and both contact pads extend at least almost from a rear-side end region of the bottom surface adjoining the rear-side surface to a front-side end region of the bottom surface adjoining the front-side surface. This embodiment with the two contact pads on the bottom surface of the LED die allows a free exposed region between the two contact pads for the light emitted in the LED die to radiate additionally from the exposed region of the bottom surface. The result of this kind of setup is an improved light distribution with an increased efficiency of the LED light emission.

Concerning this matter the light distribution is at least in all directions from the outer surfaces of the LED die with the result of an about 360° light distribution. Consequently this kind of LED device allows the homogenous light distribution similar to conventional light bulbs.

According to a preferred embodiment, the free end region of each of the tongue-like elements forms a T-shaped extension, whereby the T-shaped extension is used for connecting the respective contact pads of two adjacent LED dies. This embodiment is a specific arrangement to hold the respective LED dies by the respective tongue-like elements. Furthermore, the T-shaped extension allows a lateral downward radiation of the light from the LED die in an optimized manner, due to the fact, that only the T-shaped extensions hold the respective LED dies in the heat zone and covering at least almost completely the respective contact pad at the bottom surface of the LED die and not the complete cross section of the bottom surface of the LED die. Therefore an increased light distribution can be effected by this kind of LED device.

According to a preferred embodiment, the distance between the respective two adjacent cooling and supporting sheets in the cooling-down zone is smaller than the distance between the two contact pads of the respective LED die in the heat zone. This embodiment has the positive effect that the cooling-down zone is as wide as possible for an improved cooling effect. In addition the distance between two contact pads of one LED die defines the exposed region for the light which radiates form the LED die towards the bottom surface of the LED die. Thus, with this kind of setup an increased cooling effect coupled with an optimized light distribution is possible.

According to a preferred embodiment, the width of the cooling and supporting sheets is greater than the width of the tongue-like elements measured orthogonally to the longitudinal axis and parallel to the upper outer surface and lower outer surface. This embodiment results in an optimized heat distribution by an optimized transfer of the heat from the respective LED die to the two adjacent tongue-like elements in the heat zone and from there to the cooling and supporting sheets in the cooling-down zone.

According to a preferred embodiment, a first cooling and supporting sheet and a last cooling and supporting sheet of the number of cooling and supporting sheets are used as electrical terminals for electrical connection with a voltage generator. The voltage generator is used to supply electrical current through the number of LED dies connected in series via the respective tongue-like elements. This embodiment allows the electrical connection between the number of LED dies without wire-bonding.

Preferably, the first cooling and supporting sheet, the last cooling and supporting sheet as well as the number of cooling and supporting sheets are electrically conductive for the electrical connection of the number of LED dies in series. Therefore, this kind of LED device with the LED dies and the respective tongue-like elements is similar to the flip-chip-technology.

According to the third aspect of the present invention the cooling and supporting sheets are used as carrier substrates to hold the respective LED dies, as electrical connectors to electrically connect the LED dies in series and additionally as cooling elements to transfer the heat generated in the LED dies to the cooling and supporting sheets in the cooling-down zone.

According to a preferred embodiment, the lower outer surface of the cooling and supporting sheet and cooling and supporting sheets, respectively, and the tongue-like elements are supported at least almost area-wide by a single carrier substrate. The single carrier substrate is preferably planar with preferably a circular or rectangular shape, preferably comprises or is made of a transparent or translucent material and preferably comprises thermal conductive and electrical insulating properties. This embodiment with the single carrier substrate protects the LED dies from below and allows furthermore the radiation of light from the exposed region between the two contact pads at the bottom surface of the LED die due to the specific arrangement of the two adjacent tongue-like elements with respect to the respective LED die.

According to a preferred embodiment, the lower outer surface of the cooling and supporting sheet and cooling and supporting sheets, respectively, is supported at least almost area-wide by a single carrier substrate. The single carrier substrate is preferably planar with preferably a circular or rectangular shape, preferably comprises or is made of a transparent or translucent material and preferably comprises thermal conductive and electrical insulating properties. The tongue-like elements protrude the carrier substrate. Regarding this embodiment the single carrier substrate is exclusively part of the cooling-down zone and is used to additionally support the cooling effect of the cooling and supporting sheets.

According to a preferred embodiment, a further single carrier substrate is supported at least almost area-wide by the upper outer surface of the cooling and supporting sheet and cooling and supporting sheets, respectively. The further single carrier substrate is preferably planar with preferably a circular or rectangular shape, preferably comprises or is made of a transparent or translucent material and preferably comprises thermal conductive and electrical insulating properties. Regarding this embodiment the tongue-like elements protrude the further single carrier substrate. The further single carrier substrate is exclusively part of the cooling-down zone and is also used to additionally support the cooling effect of the cooling and supporting sheets.

Concerning this matter the single carrier substrate and the further single carrier substrate are used in a kind of a sandwich arrangement covering the cooling and supporting sheet and cooling and supporting sheets, respectively, in order to additionally support the cooling effect of the LED device.

According to a preferred embodiment, a cooling element is supported at least almost area-wide by the single carrier substrate, whereby the cooling element is preferably planar with preferably a circular or rectangular shape and is preferably made of cooper, and preferably a further cooling element is supported at least almost area-wide by the further single carrier substrate, whereby the further cooling element is preferably planar with preferably a circular or rectangular shape and is preferably made of cooper. This embodiment comprises an optimized sandwich arrangement with the cooling element, the single carrier substrate, the cooling and supporting sheet and cooling and supporting sheets, respectively, the further single carrier substrate and the further cooling element in the cooling-down zone for an improved cooling effect with this LED device. Therefore this kind of sandwich arrangement supports the increased life time corresponding with the deceleration of the material aging of this LED device.

According to a preferred embodiment, a cooling element is supported at least almost area-wide by the single carrier substrate, whereby the cooling element is preferably planar with preferably a circular or rectangular shape and is preferably made of cooper, and a comb-shaped heat sink is supported at least almost area-wide by the further single carrier substrate, whereby the comb-shaped heat sink preferably comprises a circular or rectangular shape and is preferably made of cooper. According to this embodiment an alternative optimized sandwich arrangement of the cooling element, the single carrier substrate, the cooling and supporting sheet, the further single carrier substrate and the comb-shaped heat sink in the cooling-down zone with a further improved cooling effect is possible. Therefore this kind of sandwich arrangement further increases the life time of the LED device.

Preferably, in case the LED dies being arranged on the end face of the tongue-like elements according to the second aspect of the present invention, the single cooling and supporting sheet comprises - in an unwrapped state - an at least almost rectangular shape and - in a wrapped state - the single cooling and supporting sheet is arranged on a lateral surface of a drum-like carrier element. According to this embodiment, in the wrapped state the tongue-like elements protrude from an upper end of the drum-like carrier element and build up a crown-like arrangement.

The drum-like carrier element preferably comprises or is made of a non-electrical material and preferably comprises or is made of a thermal conductive material. Thus, this embodiment of the crown-like arrangement has an improved cooling effect due to the setup of the cooling and supporting sheet with respect to the drum-like carrier element and is part of the cooling-down zone.

Preferably, the material of the drum-like carrier element is polycarbonate.

Preferably, the rectangular-shaped cooling and supporting sheet is held by the lateral surface of the drum-like carrier element and a clamping ring surrounding the cooling and supporting sheet. The clamping ring has a holding function for the wrapped cooling and supporting sheet.

According to a preferred embodiment, the LED dies are mechanically carried exclusively by tongue-like elements. Thus the tongue-like elements are of sufficient mechanical strength to carry the respective LED dies without any further submount element.

According to a preferred embodiment, the LED dies comprises or are made of a transparent or translucent material to allow light emitted from the LED dies to travel through the translucent material in all directions to the surfaces of the LED dies. This specific material property results in a more efficient light emission inside the LED die materials.

According to a preferred embodiment, the LED dies comprises or are made of a thermal conductive material, preferably sapphire, for transporting heat generated inside the LED dies to the surrounding. The thermal conductivity of the LED die materials defines the heat distribution between the different layers of the LED die materials and results in a respective heat emission of the LED dies. To control the heat distribution inside the LED dies and to avoid defects due to the heat the LED dies are arranged in the end region of the tongue-like elements for an optimized heat distribution of the LED devices according to the present invention.

According to a preferred embodiment, the LED dies are surrounded by an encapsulation material, preferably silicone, whereby the encapsulation material comprises a light converting material, preferably a phosphor material. The encapsulation material is used to protect and possibly to cool the light converting material from the heat which is generated by the LED dies.

Preferably, the encapsulation material, especially silicone, has a refractive index similar to the refractive index of the LED die materials in order to avoid a loss of the light emission during the light transfer from the LED die materials to the surrounding.

Especially, the refractive index of air is lower than the refractive index of the LED die materials, so that in the present invention all embodiments are designed in that way, that the difference between the refractive indices of the materials used in the heat zone in connection with the LED devices are as small as possible to avoid the loss of the light emission.

The light converting material, preferably the phosphor material, is used to convert the wavelength of the LED dies into different wavelengths for different colors of light.

According to a preferred embodiment, the light converting material is a number of phosphor particles which are embedded in a silicone matrix. This has the effect that the light which radiates form the LED dies comprises a specific wavelength which can be converted by the specific number of phosphor particles in the silicone matrix into different wavelengths for different colors of light.

Preferably, the silicone as the encapsulation material is a droplet-like silicone or a strang-like silicone. In case of the droplet-like silicone each LED die is embedded separately and in case of the strang-like silicone a number of LED dies in a row being embedded.

According to a preferred embodiment, the LED dies are surrounded by the encapsulation material, which is coated on an outer side with the light converting material. Preferably, the encapsulation material is made of transparent or translucent material to allow the light which radiates from the LED dies to travel through the encapsulation material to the light converting material, whereby the light converting material converts the light with the respective wavelength from the LED dies into different wavelengths for different colors of light. Especially the thickness of the light converting material on the outside of the strang-like silicone defines the specific wavelength for the specific color of light.

According to a preferred embodiment, the LED dies are surrounded by the encapsulation material, whereby the encapsulation material is coated on the outer side with a glass material which is coated on an outer side or an inner side with the light converting material. The glass material has the effect to protect the LED dies against the surrounding because the glass material has a sufficient robustness.

In accordance with a fourth aspect of the present invention there is provided a Light Emitting Diode (LED) device comprising a number of LED dies with a top surface, a bottom surface, a left-side surface, a right-side surface, a front-side surface and a rear-side surface. Two contact pads are formed on the top surface of each LED die and are spaced apart from each other. At least the number of LED dies, preferably all LED dies, are electrically connected in series by means of wire bonding. The LED device further comprises a number of electrical and thermal conductive cooling and supporting sheets being spaced apart from each other and comprising an upper outer surface and a lower outer surface. Each of the cooling and supporting sheets is formed integrally with and protruding from a single tongue-like element. Each of the tongue-like elements defines a longitudinal axis and comprises a free end region. Each of the LED dies is electrically connected with its two contact pads to the respective upper outer surface of the free end region of two adjacent tongue-like elements by wire bonding. The free end regions of the respective two adjacent tongue-like elements are spaced apart from the respective LED die. The LED dies are mechanically held by the wire bonds and the tongue-like elements build up a heat zone and the cooling and supporting sheets build up a cooling-down zone. This embodiment comprises an improved light distribution due to the setup of the respective LED die with respect to two adjacent tongue-like elements in the heat zone. In addition this embodiment comprises an improved cooling effect for the LED dies by an optimized heat transfer from the LED dies in the heat zone to the two adjacent cooling and supporting sheets as part of the cooling-down zone.

As mentioned in the introduction part of the present invention the light emitted by the LED dies radiates in an angle of 120° out from the surfaces of the LED dies. For the LED device according to the fourth aspect of the present invention the light which radiates from the LED dies is blocked in the upward direction to the top surface of the LED dies by the respective two contact pads. Thus, the bottom surface, the left-side surface, the right-side surface, the front-side surface, the rear-side surface as well as an exposed region on the top surface beside the respective two contact pads are exposed for an about 360° light distribution with the positive effect of an improved light distribution and a corresponding homogenous lightning effect for this LED device similar to conventional light bulbs.

Due to the thermal properties of the two respective wire-bonds, the two adjacent tongue-like elements and the two adjacent cooling and supporting sheets the heat is transferred from the respective LED dies along the respective two wire-bonds to the two adjacent tongue-like elements in the heat zone and from there to the two adjacent cooling and supporting sheets in the cooling-down zone. Therefore, an optimized heat distribution for this LED device is possible with the beneficial effect of an increased life time corresponding with a deceleration of the material aging.

Preferably, the wire-bonds are made of aluminum and gold, respectively, and the length is preferably below 1.0 mm.

Preferably, the wire-bonds made of aluminum comprising a diameter of about 30 µm or more.

Preferably, the wire-bonds made of gold comprising a diameter of between about 35 µm and about 50 µm with preferably a length of about 0.7 mm.

Further embodiments of the present invention are described in the following drawings:
- Fig. 1: a schematic perspective view of a LED device according to a first embodiment with regard to the third aspect of the present invention mentioned in the introduction part of this application comprising a series of six cooling and supporting sheets, whereby from each of them formed integrally with and protruding from a single tongue-like element, and whereby a free end region of respective two adjacent tongue-like elements supporting a respective LED die in a heat zone;
- Fig. 2: a schematic perspective top view of an enlarged section A of the LED device shown in Fig. 1;
- Fig. 3: a schematic perspective bottom view of the LED device shown in Fig. 2;
- Fig. 4: a schematic perspective view of the LED device of Fig. 1 arranged on a single carrier substrate;
- Fig. 5: a schematic perspective view of the LED device of Fig. 1 arranged on a single rectangular-shaped carrier substrate, whereby the tongue-like elements which supports the five LED dies protrude from the single rectangular-shaped carrier substrate;
- Fig. 6: a schematic perspective view of the LED device of Fig. 1 with a sandwich arrangement comprising a single carrier substrate and a further single carrier substrate as well as a cooling element and a further cooling element in the cooling-down zone for an improved cooling effect, whereby the tongue-like elements which supports the five LED dies protrude from the sandwich arrangement in the heat zone;
- Fig. 7: a schematic perspective view of the LED device of Fig. 1 with the sandwich arrangement of Fig. 6, whereby a strang-like encapsulation material surrounds the five LED dies in the heat zone;
- Fig. 8: a schematic perspective view of the LED device of Fig. 1 with a sandwich arrangement of Fig. 6, whereby instead of the further cooling element a comb-shaped cooling element is used for an improved cooling effect;
- Fig. 9: a schematic perspective view of the LED device of Fig. 1 with a sandwich arrangement of Fig. 8, whereby instead of the strang-like encapsulation material a droplet-like encapsulation material surrounds each of the five LED dies in the heat zone;
- Fig. 10: a schematic perspective top view of an enlarged section of a LED device according to the first embodiment with regard to the third aspect of the present invention mentioned in the introduction part of this application comprising a number of cooling and supporting sheets arranged in a circular manner, whereby from each of them formed integrally with and protruding from a single tongue-like element, and whereby a free end region of respective two adjacent tongue-like elements supporting the respective LED die in the heat zone;
- Fig. 11: a schematic perspective view of the LED device of Fig. 10, whereby the LED device according to the first embodiment is arranged on a single circular-shaped carrier substrate;
- Fig. 12: a schematic perspective view of the LED device of Fig. 10 with the circular-shaped single carrier substrate of Fig. 11, whereby the single circular-shaped carrier substrate is supported by a bottom housing and is covered by a top housing as parts of a setup for a final LED bulb shown in Fig. 15;
- Fig. 13: a schematic perspective view of an enlarged section B of the setup shown in Fig. 12;
- Fig. 14: a schematic perspective view of Fig. 12 additionally comprising an inner heat sink arranged inside the bottom housing;
- Fig. 15: a schematic perspective view of a final LED bulb;
- Fig. 16: a schematic perspective top view of an enlarged section of a LED device according to a second embodiment with regard to the first aspect of the present invention mentioned in the introduction part of this application comprising a thermal conductive cooling and supporting sheet from which a number of tongue-like elements are arranged along an edge of the cooling and supporting sheet, whereby each LED die is arranged in a free end region of the respective tongue-like element on an upper outer surface of the respective tongue-like element;
- Fig. 17: a schematic perspective view of the LED device of Fig. 16, whereby the LED device according to the second embodiment is arranged on a single circular-shaped carrier substrate;
- Fig. 18: a schematic perspective view of the LED device of Fig. 16 with the single circular-shaped carrier substrate of Fig. 17 comprising a ring-shaped encapsulation material surrounding the LED dies in the heat zone;
- Fig. 19: a schematic perspective view of an enlarged section of a LED device - in an unwrapped state - according to a third embodiment with regard to the second aspect of the present invention mentioned in the introduction part of this application comprising a thermal conductive cooling and supporting sheet from which a number of tongue-like elements are arranged along an edge of the cooling and supporting sheet, whereby each LED die is arranged on an end face of the respective tongue-like element;
- Fig. 20: a schematic perspective view of the LED device according to the third embodiment of Fig. 19 wrapped around a drum-like carrier element for a crown-like arrangement;
- Fig. 21: a schematic perspective view of a number of cooling and supporting sheets arranged - in the unwrapped state - in a pile and each of them are separated by a separation plate;
- Fig. 22: a schematic perspective view of an enlarged section B of the number of cooling and supporting sheets shown in Fig. 21;
- Fig. 23: a schematic perspective view of a first method step of wrapping one cooling and supporting sheet surround a drum-like carrier element to build up the crown-like arrangement;
- Fig. 24: an exploded schematic perspective view of a wrapped cooling and supporting sheet surrounding the drum-like carrier element of the crown-like arrangement and a clamping ring;
- Fig. 25: a schematic perspective view of the crown-like arrangement with the clamping ring holding the wrapped cooling and supporting sheet in position on the drum-like carrier element;
- Fig. 26: a schematic perspective view of the crown-like arrangement of Fig. 25 provided with a ring-shaped encapsulation material surrounding the LED dies in the heat zone and tilted by 180°, whereby the drum-like element comprises a number of slots located - in the wrapped position - in an angle of about 120° from the longitudinal axis of the drum-like carrier element to engage with parts from the single cooling and supporting sheet which being cut-off at the respective position opposite the slots in the drum-like carrier element;
- Fig. 27: a schematic perspective view of the crown-like arrangement of Fig. 26, whereby the respective parts bent inside the drum-like carrier element through the slots to hold the wrapped cooling and supporting sheet with respect to the drum-like carrier element in position;
- Fig. 28: an exploded schematic perspective view of a LED bulb setup shown in Fig. 29 comprising the LED device of Fig. 19 in the crown-like arrangement of Fig. 27 inserted in a heat sink which is inserted in a socket;
- Fig. 29: a schematic perspective view of the LED bulb setup with the crown-like arrangement inserted in the heat sink which is inserted in the socket;
- Fig. 30: a schematic perspective view of a final LED bulb comprising the LED device of the third embodiment of the present invention, whereby the LED bulb setup of Fig. 29 comprises a cover on top of the heat sink and a plug at a lower end region of the socket;
- Fig. 31: a schematic perspective view of an enlarged section of a LED device according to a fourth embodiment with regard to the fourth aspect of the present invention mentioned in the introduction part of this application comprising a number of cooling and supporting sheets, whereby from each of them formed integrally with and protruding from a single tongue-like element, so that the tongue-like elements and the cooling and supporting sheets are supported by the single rectangular-shaped carrier substrate and the LED dies being held exclusively by wire bonds in the heat zone;
- Fig. 32: a schematic perspective view of the LED device according to the fourth embodiment of Fig. 31, whereby three rows of a number of cooling and supporting sheets being arranged on a single rectangular-shaped carrier substrate;
- Fig. 33: a schematic perspective view of the LED device according to the fourth embodiment of Fig. 31, whereby three rows of the number of cooling and supporting sheets being arranged on a single rectangular-shaped carrier substrate, whereby the tongue-like elements protrude from the single rectangular-shaped carrier substrate and the respective LED dies exclusively being held by the respective two wire bonds in the heat zone; and
- Fig. 34: a schematic perspective view of Fig. 33 comprising an encapsulation material surrounding the wire bonds and the LED dies in the heat zone.

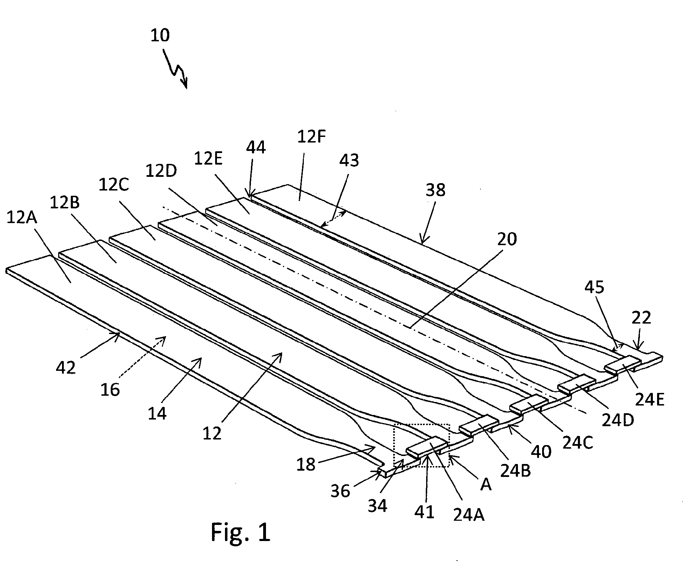

Fig. 1 schematically shows a first embodiment of a Light Emitting Diode (LED) device 10 with regard to the third aspect of the present invention mentioned in the introduction part of this application.

The LED device 10 comprises a series of six electrical and thermal conductive cooling and supporting sheets 12A - 12F being spaced apart from each other. Each of the six cooling and supporting sheets 12 comprises an upper outer surface 14 and a lower outer surface 16.

The LED device 10 is not limited by six electrical and thermal conductive cooling and supporting sheets 12. Rather than the LED device 10 could have more or less than six electrical and thermal conductive cooling and supporting sheets 12.

From each of the cooling and supporting sheets 12 protrudes one tongue-like element 18 formed integrally with the dedicated cooling and supporting sheet 12. Each of the tongue-like elements 18 defines a longitudinal axis 20 and comprises a free end region 22.

Preferably, the material of the cooling and supporting sheets 12 and tongue-like elements 18 is copper.

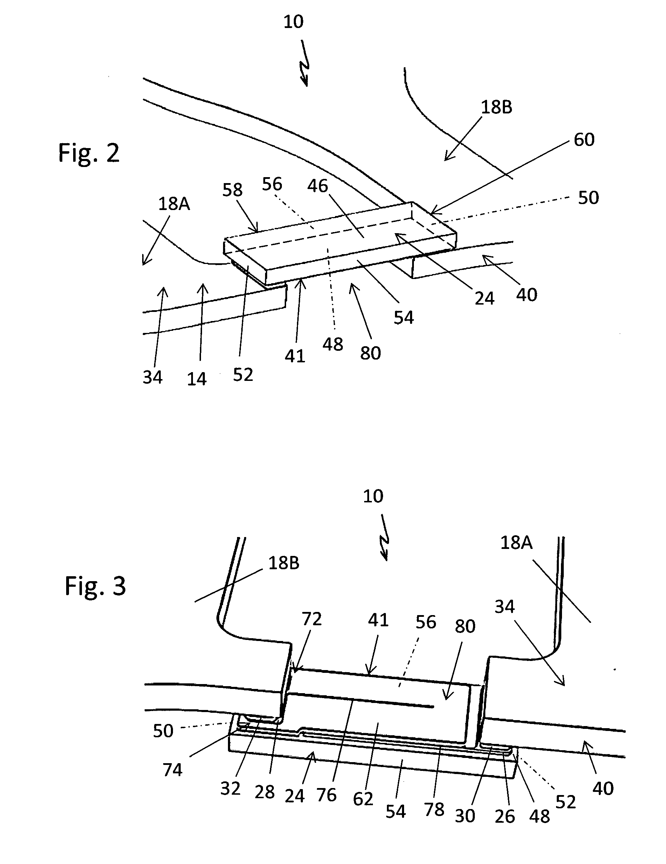

The LED device 10 further comprises five LED dies 24A - 24E. Each of the LED dies 24 being connected with its two contact pads 26, 28 (see Fig. 3) to the upper outer surface 14 of the free end region 22 of two adjacent tongue-like elements 18 by means of solder bumps 30, 32 (see Fig. 3).

The free end regions 22 of the six tongue-like elements 18 forming T-shaped extensions 34 for supporting the five LED dies 24. The T-shaped extensions 34 of the tongue-like elements 18 are used for connecting the respective contact pads 26, 28 of two adjacent LED dies 24 for building up a heat zone 36 and the cooling and supporting sheets 12 building up a cooling-down zone 38.

Because the tongue-like elements 18 are electrical conductive the five LED dies 24 are electrically connected via the tongue-like elements 18 in series.

To supply electrical current through the five LED dies 24 the first cooling and supporting sheet 12A and the last cooling and supporting sheet 12F of the six cooling and supporting sheets 12 are used as electrical terminals for electrical connection with a voltage generator (not shown).

The LED dies 24 are arranged close to an end face 40 of the respective two adjacent tongue-like elements 18 and the respective two adjacent tongue-like elements 18 at least almost completely covering the two contact pads 26, 28 and being arranged at least almost in a same distance 41 to each other as the contact pads 26, 28 (see Fig. 3).

A distance measured from the upper outer surface 14 to the lower outer surface 16 of each of the cooling and supporting sheets 12 defines its thickness 42. The thickness 42 is between about 70 µm and about 200 µm, more preferably about 100 µm in order to have a sufficient mechanical strength to support the LED dies 24. A thickness below 35 µm is not useful for this application.

A distance 44 between two adjacent cooling and supporting sheets 12 in the cooling-down zone 38 is smaller than the distance 41 between the two contact pads 26, 28 of the respective LED die 24 in the heat zone 36.

Preferably, the distance 44 between the respective two adjacent cooling and supporting sheets 12 in the cooling-down zone 38 is between about 70 µm and about 200 µm, more preferably about 100 µm and the distance 41 between the two contact pads 26, 28 of the respective LED die 24 in the heat zone 36 is between about 480 µm and about 520 µm, more preferably about 500 µm.

For an optimized setup of the respective cooling and supporting sheets 12 in the row the distance 44 between two adjacent cooling and supporting sheets 12 is equal or greater than the thickness 42 of the respective cooling and supporting sheets 12.

A width 43 of each of the cooling and supporting sheets 12 is greater than a width 45 of each of the tongue-like elements 18 measured orthogonally to the longitudinal axis 20 and parallel to the upper outer surface 14 and the lower outer surface 16.

Preferably the width 45 of each of the tongue-like elements 18 is between about 400 µm and about 1.0 mm, more preferably about 700 µm and the width 43 of each of the cooling and supporting sheets 12 in the cooling-down zone 36 is between about 1.0 mm and about 2.0 mm, more preferably about 1.5 mm.

Regarding the first embodiment of the present invention, as shown in Fig. 1, each of the LED dies 24 is exclusively mechanically carried by the respective two tongue-like elements 18.

Furthermore, each of the cooling and supporting sheets 12 as well as the tongue-like elements 18 comprises electrical conductive properties, on the one hand, for the electrical connection of the first cooling and supporting sheet 12A and the last cooling and supporting sheet 12F with the voltage generator and, on the other hand, for the electrical connection of the LED dies 24 in series. By this kind of setup wire bonding is not necessary with the positive effect of a very practical handling and manufacturing the LED device 10 according to the first embodiment of the present invention.

In addition the cooling and supporting sheets 12 as well as the tongue-like elements 18 comprises thermal conductive properties with the positive effect that the heat generated by each of the LED dies 24 in the heat zone 36 can be transferred to the cooling-down zone 38 in an optimized way with the result of an improved heat distribution.

Fig. 2 schematically shows an enlarged section A of Fig. 1 regarding the top view of the LED device 10 according to the first embodiment of the present invention.

Each LED die 24 has, as well-known, a number of typical LED material layers of a P-type semiconductor material, a N-type semiconductor material and an active layer between the P-type semiconductor material and the N-type semiconductor material.

Each of the LED dies 24 is of cuboid shape and has a top surface 46, a bottom surface 48, a right-side surface 50, a left-side surface 52, a front-side surface 54 and a rear-side surface 56.

Each of the LED dies 24 has preferably a LED die length 58 of about 660 µm ± 20 µm (26 mil) and a LED die width 60 of about 260 µm ± 20 µm (10 mil).

Fig. 3 schematically shows the enlarged view of the LED device 10 of Fig. 2 being turned upside down by 180°.

On the bottom surface 48 of the LED die 24 is arranged the left-hand contact pad 26 and the right-hand contact pad 28. The left-hand contact pad 26 and the right-hand contact pad 28 are rectangular-shaped and are separated apart from each other by the distance 41.

The left-hand contact pad 26 and the right-hand contact pad 28 are electrically insulated from each other by means of an insulating layer 62.

The insulating layer 62 comprises or is made of a translucent or transparent material to allow light generated from the LED dies 24 to travel through the insulating layer 62.

Preferably, the thickness of the insulating layer 62 is between about 0.8 µm and about 1.2 µm, more preferably about 1.0 µm.

Furthermore the insulating layer 62 comprises non-electrical properties to avoid current flow between the left-hand contact pad 26 and the right-hand contact pad 28.

The left-hand contact pad 26 is on top of the P-type semiconductor material and comprises preferably a P-pad length of about 186 µm ± 10 µm (7.4 mil) and a P-pad width of about 80 µm ± 10 µm (3.2 mil).

The right-hand contact pad 28 is on top of the N-type semiconductor material and comprises preferably a N-pad length of about 224 µm ± 10 µm (8.9 mil) and a N-pad width of about 80 µm ± 10 µm (3.2 mil).

As can be seen from Fig. 3, the left-hand contact pad 26 of the LED die 24 is arranged adjacent to the left-side surface 52 and the right-hand contact pad 28 of the LED die 24 is arranged adjacent to the right-side surface 50 of the LED die 24. Both contact pads 26, 28 extend at least almost from a rear-side end region 72 of the bottom surface 48 adjoining the rear-side surface 56 to a front-side end region 74 of the bottom surface 48 adjoining the front-side surface 54.

Preferably the rear-side end region 72 and the front-side end region 74 are as small as the rectangular-shaped contact pads 26, 28 being formed on the bottom surface 48 of the LED dies 24 in an optimized manner for the electrical and thermal propose in connection with the first embodiment of the present invention.

A small strip 76 protrudes from the right-hand contact pad 28 and extends in the direction to the left-hand contact pad 26 on the bottom surface 48 of the LED die 24 adjacent to the rear-side end region 72 and a further small strip 78 protrudes from the left-hand contact pad 26 and extends in the direction to the right-hand contact pad 28 on the bottom surface 48 of the LED die 24 adjacent to the front-side end region 74 of the LED die 24.

The small strips 76, 78 are as small as possible to be able to supply sufficient current to the P-type and N-type semiconductor material without blocking the emitted light from the LED die 24 in the direction to the bottom surface 48 between the left-side contact pad 26 and the right-side contact pad 28.

Preferably, the width of the small strips 76, 78 is between about 18 µm and about 22 µm, preferably about 20 µm and the thickness of the small strips 76, 78 is between about 0.8 µm and about 1.2 µm, more preferably about 1.0 µm.

By this kind of arrangement and construction of the two contact pads 26, 28 on the bottom surface 48 of the LED die 24 the light emitted from the LED die 24 is able to radiate through an exposed region 80. The distance 41 between the left-hand contact pad 26 and the right-hand contact pad 28 is about 500 µm ± 20 µm and defines the dimension of the exposed region 80 of the bottom surface 48 of the LED die 24.

Compared to the state of the art LED device mentioned in the introduction part of this application the LED device 10 according to the first embodiment of the present invention as shown in Fig. 1 to Fig. 3 has the positive effect that only the light which radiates from the LED dies 24 is blocked in the downward direction to the bottom surface 48 of the LED dies 24 by the respective two contact pads 26, 28 and in the lateral downward directions from the left-side surface 52 and right-side surface 50 of the LED dies 24 by the two adjacent tongue-like elements 18. Thus, the top surface 46, the exposed region 80 on the bottom surface 48 beside the respective two contact pads 26, 28, the front-side surface 54 and the rear-side surface 56 of the LED dies 34 are exposed for an about 360° light distribution. Thus an improved light distribution and a corresponding homogenous lightning effect for this LED device 10 are possible similar to conventional light bulbs.

According to Fig. 2 and Fig. 3, the upper outer surface 14 of the T-shaped extension 34 of the first tongue-like element 18A is arranged opposite the left-hand contact pad 26 and is electrically connected by means of the left-hand solder bump 30 and the upper outer surface 14 of the T-shaped extension 34 of the adjacent tongue-like element 18B is arranged opposite the right-hand contact pad 28 and is electrically connected by means of the right-hand solder bump 32. The electrical connection between the LED dies 24 and the tongue-like elements 18 is similar to the flip-chip technology.

The solder bumps 30, 32 typically comprises a ball size with a length of between about 180 µm to about 220 µm, preferably about 200 µm and a width of between about 78 µm to about 82 µm, preferably about 80 µm. The dimension of the contact pads 26, 28 allows enough space for the solder bumps 30, 32 together with a solder paste for a high strength and solderability.

Preferably, the upper outer surface 14 of the T-shaped extension 34 of the first tongue-like element 18A covering exclusively the left-hand contact pad 26 and the upper outer surface 14 of the T-shaped extension 34 of the adjacent tongue-like element 18B covering exclusively the right-hand contact pad 28 of the respective LED die 24.

Preferably, the T-shaped extensions 34 opposite the respective contact pads 26, 28 have the same dimension or being smaller in size. Thus, the T-shaped extension 34 of the first tongue-like element 18A and the T-shaped extension 34 of the adjacent tongue-like element 18B are spaced apart from each other by the same distance 41 as the left-hand contact pad 26 to the right-hand contact pad 28 on the bottom surface 48 of the LED die 24. Consequently the exposed region 80 is defined between the two contact pads 26, 28 as well as between the two adjacent T-shaped extensions 34 of the respective two adjacent tongue-like elements 18A, 18B.

The LED device 10 according to Fig. 1 of the first embodiment with regard to the third aspect of the present invention mentioned in the introduction part of this application has at least two beneficial effects:

This LED device 10 comprises an improved light distribution due to the setup of the respective LED die 24 with respect to two adjacent tongue-like elements 18 in the heat zone 36. In addition this LED device 10 comprises an improved cooling effect for the LED dies 24 by an optimized heat transfer from the LED dies 24 in the heat zone 36 to the two adjacent cooling and supporting sheets 12 as part of the cooling-down zone 38.

As mentioned in the introduction part of this application the light emitted by the LED dies 24 radiates in an angle of 120° out from the surfaces 46, 48, 50, 52, 54 and 56 of the LED dies 24. For this LED device 10 according to the first embodiment of the present invention the light which radiates from the LED dies 24 is blocked in the downward direction to the bottom surface 48 of the LED dies 24 by the respective two contact pads 26, 28 and in the lateral downward directions from the left-side surface 52 and right-side surface 50 of the LED dies 24 by the two adjacent tongue-like elements 18A, 18B. Thus, the top surface 46, the exposed region 80 on the bottom surface 48 beside the respective two contact pads 26, 28, the front-side surface 54 and the rear-side surface 56 of the LED dies 24 are exposed for an about 360° light distribution with the positive effect of an improved light distribution and a corresponding homogenous lightning effect for this LED device 10 similar to conventional light bulbs.

Due to the thermal properties of the two adjacent tongue-like elements 18 and the two adjacent cooling and supporting sheets 12, the heat is transferred from the respective LED die 24, which is arranged on the free end regions 22 of the two adjacent tongue-like elements 18 in the heat zone 36, to the two adjacent cooling and supporting sheets 12 in the cooling-down zone 38. Therefore, an optimized heat distribution for the LED device 10 is possible with the beneficial effect of an increased life time corresponding with a deceleration of the material aging.

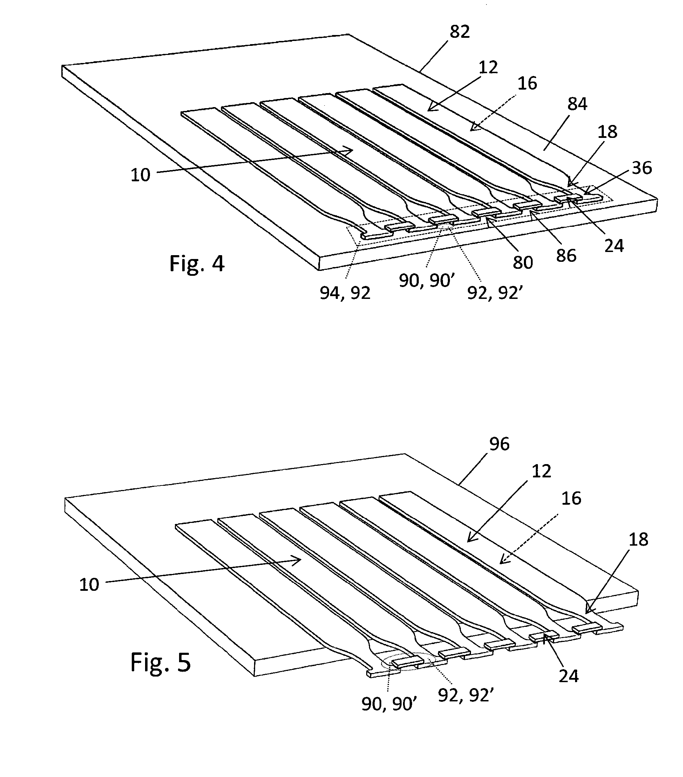

Fig. 4 schematically shows the LED device 10 of the first embodiment of Fig. 1 which is attached on a top surface 84 of a single carrier substrate 82, whereby the lower outer surfaces 16 of the cooling and supporting sheets 12 and tongue-like elements 18 are supported at least almost area-wide by the single carrier substrate 82.

The single carrier substrate 82 is planar with a rectangular shape, comprises or is made of a transparent or translucent material and comprises or is made of thermal conductive and electrical insulating properties.

Preferably, the single carrier substrate 82 made of transparent material is glass with a thermal conductivity less or equal than 10 W/mK.

Due to the fact that the single carrier substrate 82 is arranged under each of the LED dies 24 in the heat zone 36 results in a number of gaps 86 between the top surface 84 of the single carrier substrate 82 and the bottom surfaces 48 of the LED dies 24.

The light emitted from the LED dies 24 radiates in at least all directions through the exposed surfaces of the LED dies 24 as mentioned above. Especially that part of the light which radiates through the exposed regions 80 at the bottom surface 48 of the LED dies 24 between the two contact pads (not shown) can further radiate through the gaps 86 and from there into the single carrier substrate 82 from the top surface 84 in the heat zone 36 and from there through the material to the surrounding with the result of an improved light distribution.

In combination with the improved light distribution the single carrier substrate 82 further assists an improved cooling effect by transferring the heat from the cooling and supporting sheets 12 and tongue-like elements 18 in the downward direction.

In a preferred embodiment an encapsulation material 90 in the shape of a droplet, preferably a droplet-shaped silicone 90', is arranged inside the gaps 86 to increase the cooling effect of the LED dies 24. A number of light converting materials 92, preferably a number of phosphor particles 92', are embedded in a matrix of the droplet-shaped silicone 90' to convert the wavelength of the light, which emits from the LED dies 24, into different wavelengths for different colors of light. The number of phosphor particles 92' inside the droplet-shaped silicone 90' defines a specific wavelength for a respective color of light.

In a further preferred embodiment the light converting material 92 is formed on the top surface 84 of the single carrier substrate 82 by a phosphor layer 94, preferably exclusively in the heat zone 36. In this case, the phosphor layer 94 converts the wavelength of the light, which emits from the LED dies 24 and travels through the gaps 86, into different wavelengths for different colors of light. The thickness of the phosphor layer 94 defines the specific wavelength for the respective color of light.

In an alternative way or additionally the encapsulation material 90 is in the shape of a ring (not shown) which is arranged close to the LED dies 24, whereby the number of phosphor particles 92' being embedded in the matrix of the silicone ring.

Fig. 5 schematically shows the LED device 10 of the first embodiment of Fig. 1 which is attached on the top surface 84 of a modified single carrier substrate 96, whereby exclusively the lower outer surfaces 16 of the cooling and supporting sheets 12 are supported at least almost area-wide by the modified single carrier substrate 96 and the tongue-like elements 18 protrude from the modified single carrier substrate 96.

The modified single carrier substrate 96 is planar with a rectangular shape, comprises or is made of a transparent or translucent material and comprises or is made of thermal conductive and electrical insulating properties.

Preferably, the modified single carrier substrate 96 made of transparent material is glass with a thermal conductivity less or equal than 10 W/mK.

Either, the modified single carrier substrate 96 of Fig. 5 is smaller than the single carrier substrate 82 of Fig. 4 measured in the longitudinal direction 20 of the cooling and supporting sheets 12 or the single carrier substrate 82 of Fig. 4 is exclusively attached in the cooling-down zone 38 with the cooling and supporting sheets 12 and the tongue-like elements 18 protrude from the single carrier substrate 82.

The thickness of the single carrier substrate 82 shown in Fig. 4 as well as the modified single carrier substrate 96 shown in Fig. 5 is between about 100 µm and about 1.0 mm, preferably 800 µm.

The single carrier substrate 82 and the modified single carrier substrate 96 have the function of an electrical insulator to avoid an electrical connection of the parallel arranged cooling and supporting sheets 12.

In a preferred embodiment the encapsulation material 90 in the shape of the droplet, preferably the droplet-shaped silicone 90', is arranged surround each of the LED dies 24 to increase the cooling effect of the LED dies 24. A number of light converting materials 92, preferably a number of phosphor particles 92', are embedded in a matrix of the droplet-shaped silicone 90' to convert the wavelength of the light, which emits from the LED dies 24, into different wavelengths for different colors of light. The number of phosphor particles 92' inside the droplet-shaped silicone 90' defines a specific wavelength for a respective color of light.

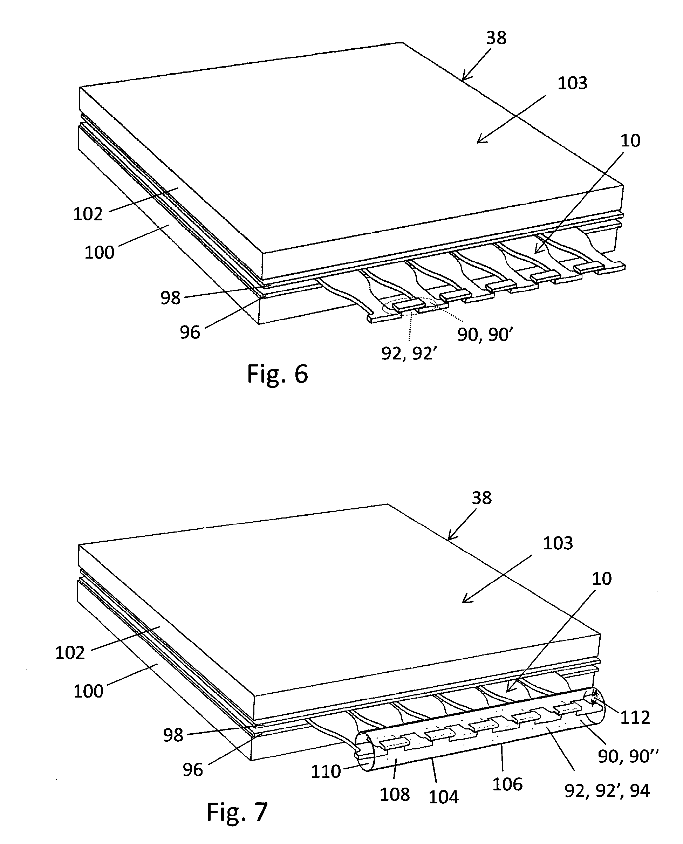

Fig. 6 schematically shows the LED device 10 of the first embodiment of Fig. 1 which is attached on the top surface 84 of the modified single carrier substrate 96 as shown in Fig. 5 and additionally a further single carrier substrate 98 is supported at least almost area-wide by the upper outer surface 16 of the cooling and supporting sheets 12.

The further single carrier substrate 98 is planar with a rectangular shape, preferably comprises or is made of a transparent or translucent material and preferably comprises or is made of thermal conductive and electrical insulating properties.

In this embodiment according to Fig. 6 the tongue-like elements 18 protrude from the further single carrier substrate 98. The further single carrier substrate 98 is exclusively part of the cooling-down zone 38 and is also used to additionally assist the cooling effect of the cooling and supporting sheets 12. Concerning this matter the single carrier substrate 96 and the further single carrier substrate 98 are used in a kind of a sandwich arrangement 103 covering the cooling and supporting sheets 12 in the cooling-down zone 38 in order to additionally assist the cooling effect of the LED device 10.

The embodiment of Fig. 6 further comprises a cooling element 100 which is attached at least almost area-wide to the single carrier substrate 96 and a further cooling element 102 which is attached at least almost area-wide to the further single carrier substrate 98.

The further single carrier substrate 98 and the single carrier substrate 96 are preferably of the same dimension.

The sandwich arrangement 103 in Fig. 6 is defined by the further cooling element 102, the further single carrier substrate 96, the cooling and supporting sheets 12, the single carrier substrate 96 and the cooling element 100 as parts of the cooling-down zone 38 for further improving the cooling effect of the LED device 10 according to the first embodiment of the present invention.

The cooling element 100 and the further cooling element 102 are planar with a rectangular shape and preferably comprise or are made of a material with good thermal properties, preferably cooper or aluminum, in order to additionally transport the heat generated from the LED dies 24 to the surrounding in an optimized manner.

The thickness of the planar cooling element 100 and the planar further cooling element 102 is between about 100 µm and about 1.0 mm, preferably about 800 µm.

Concerning the embodiment as shown in Fig. 6, this device can be used as a high power LED device because the heat generated in the LED dies 24 can easily transferred by means of the cooling element 100 and further cooling element 102 with an improved cooling effect.

In a preferred embodiment the encapsulation material 90 in the shape of the droplet, preferably the droplet-shaped silicone 90', is arranged surround each of the LED dies 24 to increase the cooling effect of the LED dies 24. A number of light converting materials 92, preferably a number of phosphor particles 92', are embedded in a matrix of the droplet-shaped silicone 90' to convert the wavelength of the light, which emits from the LED dies 24, into different wavelengths for different colors of light. The number of phosphor particles 92' inside the droplet-shaped silicone 90' defines a specific wavelength for a respective color of light.

Fig. 7 schematically shows a modified embodiment of Fig. 6 with the difference that the encapsulation material 90 surrounds all five LED dies 24 by a strang-like silicone 90". A number of light converting materials 92, preferably a number of phosphor particles 92', are embedded in a matrix of the strang-like silicone 90" to convert the wavelength of the light, which emits from the LED dies 24, into different wavelengths for different colors of light. The number of phosphor particles 92' inside the strang-like silicone 90" defines a specific wavelength for a respective color of light.

Preferably, an outer side 104 of the stang-like silicone 90" is coated with a glass material 106. This glass material 106 is especially used to protect the LED dies 24 with respect to the surrounding.

In a preferred embodiment of Fig 7, either, a number of light converting materials 92, preferably a number of phosphor particles 92', being embedded in a matrix of the stang-like silicone 90" or the phosphor layer 94 is provided on an outer side 108 or an inner side 110 of the glass material 106 to convert the wavelength of the light, which emits from the LED dies 24, into different wavelengths for different colors of light.

A distance 112 from the outer side 104 of the encapsulation material 90 or the outer side 108 of the glass material 106 to the LED dies 24 is between about 1.0 mm and about 1.5 mm, preferably about 1.25 mm.

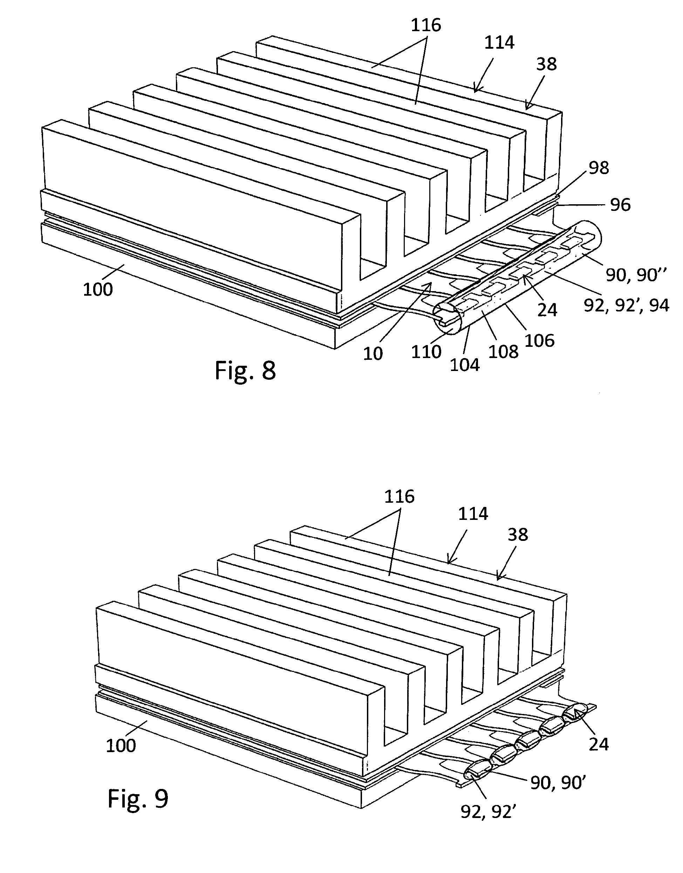

Fig. 8 schematically shows a modified embodiment of Fig. 7 with the only difference that the further cooling element 102 is exchanged by a comb-shaped heat sink 114.

The comb-shaped heat sink 114 is preferably made of cooper.

An advantage of the embodiment according to Fig. 8 is, that the comb-shaped heat sink 114 has an improved cooling effect for the LED dies 24 in the cooling-down zone 38 due to the increased surface defined by each of the fingers 116 as parts of the comb-shaped heat sink 114.

Fig. 9 schematically shows a modified embodiment of Fig. 8 with the only difference that the stang-like silicone 90" is exchanged by the droplet-shaped silicone 90' which is arranged surround each of the LED dies 24 to increase the cooling effect of the LED dies 24. A number of light converting materials 92, preferably a number of phosphor particles 92', are embedded in a matrix of the droplet-shaped silicone 90' to convert the wavelength of the light, which emits from the LED dies 24, into different wavelengths for different colors of light. The number of phosphor particles 92' inside the droplet-shaped silicone 90' defines a specific wavelength for a respective color of light.

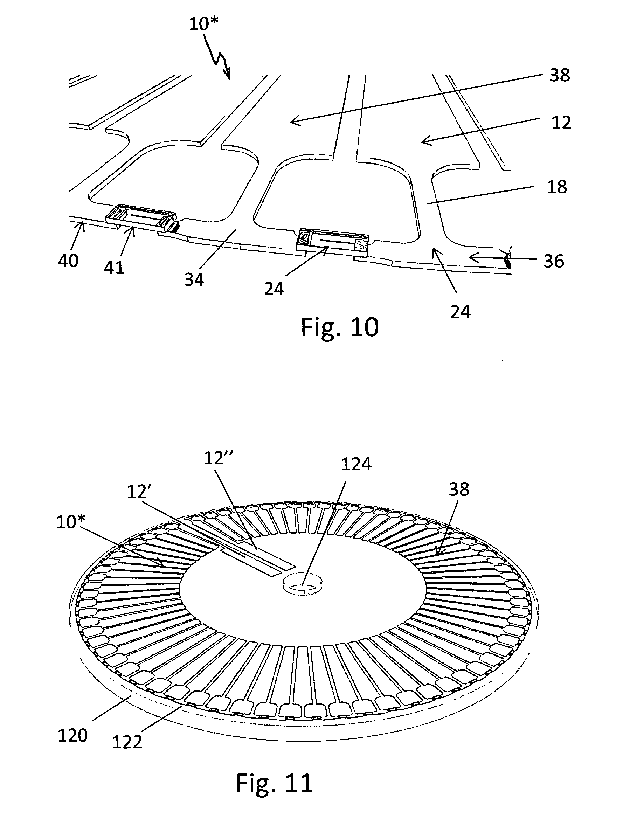

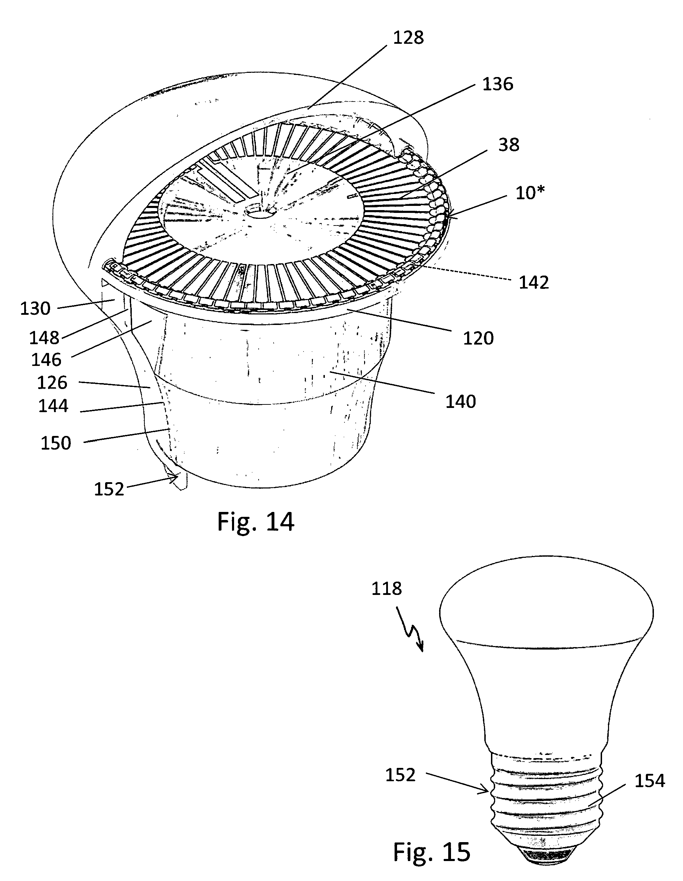

Fig. 10 to Fig. 15 schematically shows a number of method steps to fabricate a final LED bulb 118 shown in Fig. 15 based on the LED device 10 of the first embodiment according to the present invention.

Fig. 10 schematically shows a first method step to fabricate the LED bulb 118 of Fig. 15 by providing a modified embodiment 10* of the LED device 10 according to the first embodiment shown in Fig. 1. Compared to Fig. 1 in Fig. 10 - in an enlarged view - is shown a number of cooling and supporting sheets 12 being cone-shaped and being arranged in a ring-shaped manner as completely shown in Fig. 11.

The electrical and mechanical connection of the number of LED dies 24 with respect to the tongue-like elements 18 in the heat zone 36 is in a similar way as described in connection with Fig. 1 to Fig. 3 in details.

The free end regions 22 of the respective two adjacent tongue-like elements 18 supporting the respective LED die 24, building up the heat zone 36 and the cooling and supporting sheets 12 building up the cooling-down zone 38.

The respective LED dies 24 being arranged close to an end face 40 of the respective two adjacent tongue-like elements 18, whereby the respective two adjacent tongue-like elements 18 at least almost completely covering the two contact pads (not shown) and being arranged at least almost in the same distance 41 to each other as the contact pads.

Fig. 11 schematically shows a second method step to fabricate the LED bulb 118 of Fig. 15 by providing a single circular-shaped carrier substrate 120.

The LED device 10* of Fig. 10 is attached on a top surface 122 of the single circular-shaped carrier substrate 120, whereby the lower outer surfaces 16 of the cooling and supporting sheets 12 and the tongue-like elements 18 are supported at least almost area-wide by the single carrier substrate 120.

The single circular-shaped carrier substrate 120 is planar, comprises or is made of a transparent or translucent material and comprises or is made of thermal conductive and electrical insulating properties.

Preferably, the single circular-shaped carrier substrate 120 made of transparent material is glass with a thermal conductivity less or equal than 10 W/mK.

Due to the fact that the single circular-shaped carrier substrate 120 is arranged under each of the LED dies 24 in the heat zone 36 results in the number of gaps 86 between the top surface 122 of the single circular-shaped carrier substrate 120 and the bottom surfaces 48 of the LED dies 24 similar to the embodiment as shown and described in connection with Fig. 4.

The alternative use of encapsulation materials 90, preferably silicone 90', and/or light converting materials 92, preferably phosphor 92', inside the gap 86 or surrounding the LED dies 24 is well described in connection with Fig. 4.

For an electrical connection of the LED dies 24 the cooling and supporting sheets 12 are electrical conductive. Therefore wire bonding is not necessary to connect the LED dies 24 in series as shown in Fig. 10.

An electrical supply for the LED dies 24 is from a voltage generator (not shown), whereby a positive terminal of the voltage generator is connected with the first cooling and supporting sheet 12', the number of LED dies 24 are electrical connected in series in a circumferential manner and the last cooling and supporting sheet 12" is connected to a negative terminal of the voltage generator. The first cooling and supporting sheet 12' and the last cooling and supporting sheet 12" of the number of cooling and supporting sheets 12 are extending radial inwards until close to a central hole 124 for the electrical connection with the positive and negative terminals of the voltage generator.

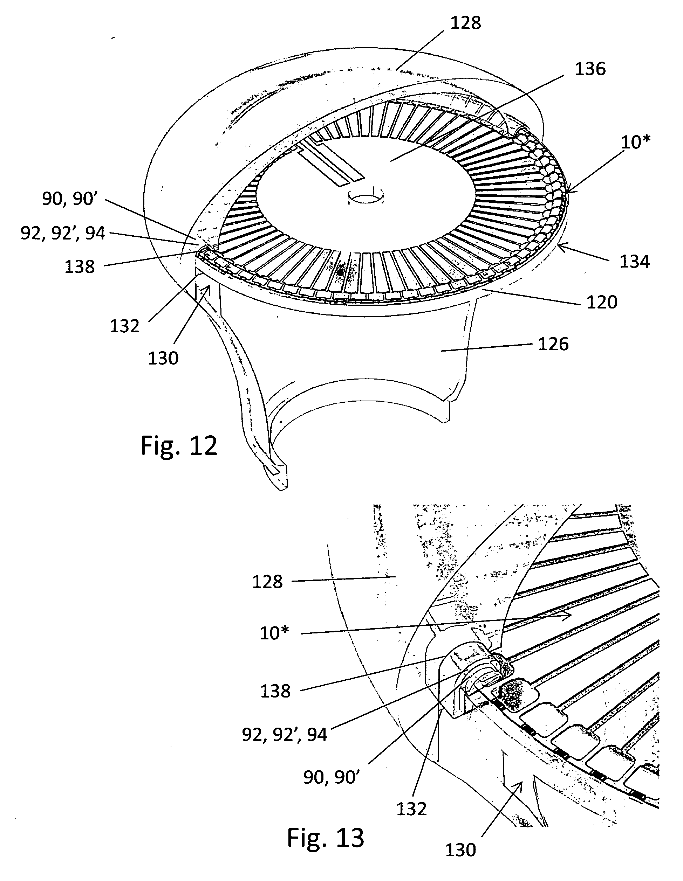

Fig. 12 schematically shows a third and fourth method step to fabricate the LED bulb 118 of Fig. 15 by providing a bottom housing 126 and a top housing 128.

The embodiment of Fig. 11 is supported by the bottom housing 126 and the top housing 128 is covering the embodiment of Fig. 11.

An upper end region 130 of the bottom housing 126 has an annular seat 132 to support an outer end region 134 of the circular-shaped single carrier substrate 120.

The top housing 128 is connected with the upper end region 130 of the bottom housing 126 for example by a chemical adhesive or glue, by cold welding or by filling the gap between the top housing 128 and bottom housing 126 with silicone in order to avoid an air gap. The air gap between the top housing 128 and bottom housing 126 must be avoided because of the different refractive index compared to the refractive index of the LED die material because this would lead to a reduced light emission.

Preferably, for an optimized light emission with respect to the LED bulb 118 the refractive indices of the top housing 128, the bottom housing 126 and the connecting material (adhesive, glue or silicone) should have at least the same refractive index as the LED die material.

The top housing 128 is bulb shaped in the cooling-down zone 38 and protects the upper side of the embodiment of Fig. 11 against any influence form the outside.

Between the top housing 128 and the cooling and supporting sheets 12 is preferably an air buffer 136 in the cooling-down zone 38. The air buffer 136 allows a reduced heat transfer in the upward direction from the cooling and supporting sheets 12 as well as from the single circular-shaped carrier substrate 120 of the embodiment shown in Fig. 11 due to the bad thermal conductivity of air.

Contrary thereto, the top housing 128 further comprises in the heat zone 36 a ring shaped recess 138, which is directly connected to the encapsulation material 90, preferably silicone 90', and/or the light converting material 92, preferably the number of phosphor particles 92' or a layer of phosphor 94 as shown in an enlarged zoom out of Fig. 13. This has the positive effect that between the ring shaped recess 138 of the top housing 128 and the light converting material 92 is no air buffer, so that the heat from the LED dies 24 in the upward direction can directly transferred to the top housing 128 for cooling propose and especially to protect the light converting material 92 against material aging.

Preferably the top housing 128 is made of glass, e.g. borosilicate, for cooling, in the heat zone 36, the light converting material 92 due to the very good thermal conductivity of the glass material, preferably borosilicate. This has the advanced effect that the aging of the phosphor material 92' can be strongly reduced. Consequently the life time of this kind of LED device 10* is improved compared to conventional LED devices as discussed in the introduction part of this application.

An important circumstance for the LED devices 10, 10* of the first embodiment with regard to the third aspect mentioned in the introduction part of this application is that the heat close to the phosphor material 92' should be strongly reduced and the heat under the LED dies 24 should be high enough to operate the LED dies 24 in an optimized temperature range for an optimized light and heat distribution of the LED device 10, 10*.

To optimize the heat distribution in the downward direction from the LED dies 24 the heat is transferred to the bottom surface 48 of the LED dies 24, from there to the two contact pads 26, 28 formed on the bottom surface 48 of the LED dies 24, from there to the two respective solder bumps 30, 32, from there to the respective T-shaped extensions 34 as parts of the tongue-like elements 18 and from there to the cooling and supporting sheets 12.

The heat in the tongue-like elements 18 as well as in the cooling and supporting sheets 12 is additionally transferred in the downward direction to the single circular-shaped carrier substrate 120 to optimize the heat distribution. By the way, the heat in the heat zone 36 is transferred in the upward direction by the ring shaped recess 138 of the top housing 128 and additionally in the downward direction by the annular seat 132 of the bottom housing 126.

Consequently, this kind of setup as shown in Fig. 12 and Fig. 13 has an increased cooling effect in the heat zone 36 in the upward and downward direction as well as in the cooling-down zone 38 in the downward direction with an improved cooling effect for the LED dies 24.

The shape of the top housing 128 and the bottom housing 126 is in the connected state as shown in Fig. 12 is similar to the conventional light bulb.

Fig. 14 schematically shows a fifth method step to fabricate the LED bulb 118 of Fig. 15 by providing an inner heat sink 140 inside the bottom housing 126 for an improved cooling effect in the cooling-down zone 38 for the heat which is transferred in the downward direction from the single circular-shaped carrier substrate 120.

The inner heat sink 142 is arranged in an interior 144 of the bottom housing 126.

An upper part 146 of the inner heat sink 140 is physically separated by an air gap 148 from the upper end region 130 of the bottom housing 126 to avoid heat transfer from the upper part 146 of the inner heat sink 140 to the upper end region 130 of the bottom housing 126 and vice versa.

A lower end region 150 of the inner heat sink 140 is partially thermo connected with a lower end region 152 of the bottom housing 126 to allow the heat exchange to the surrounding for the improved cooling effect.

For an optimized light distribution the bottom housing 126 comprises or is made of transparent or translucent material to allow the light emitted from the LED dies 24 to radiate in the downward direction through the exposed regions 80 of the bottom surface 48 of the LED dies 24.

Fig. 15 schematically shows the final LED bulb 118, whereby to a lower end region 152 of the bottom housing 126 is attached a plug 154.

Due to the inventive arrangement of the LED dies 24 in the heat zone 36 with the optimized light distribution the final LED bulb 118 has an improved lightning effect compared to conventional LED devices. The main effect is the free radiation in at least almost all directions by about 360° from the LED dies 24. Therefore the LED bulb 118 can be used as a normal light bulb with at least almost the same lighting effect.

In the following a second embodiment of a LED device with regard to the first aspect mentioned in the introduction part of this application is presented. For the same elements as described and used in connection with the first embodiment of Fig. 1 (LED device 10) and Fig. 10 (LED device 10*) we use the same wording with new reference numerals.

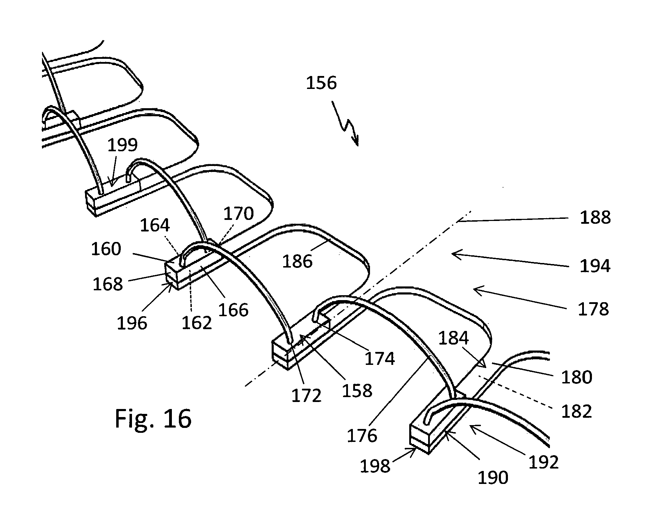

Fig. 16 schematically shows an enlarged view of the second embodiment of a Light Emitting Diode (LED) device 156 according to the present invention.

The LED device 156 comprises a number of LED dies 158 with a top surface 160, a bottom surface 162, a left-side surface 164, a right-side surface 166, a front-side surface 168 and a rear-side surface 170.

Each of the LED dies 158 has, as well known, a number of LED material layers of a P-type semiconductor material, a N-type semiconductor material and an active layer between the P-type semiconductor material and the N-type semiconductor material.

In addition each of the LED dies 158 comprises or are made of transparent or translucent material to allow light emitted from the LED dies 158 to travel through the translucent material in all directions to the respective surfaces 160, 162, 164, 166, 168, and 170 of the LED dies 158.

Two contact pads 172, 174 are formed on the top surface 160 of each of the LED dies 158 and spaced apart from each other. The LED dies 158 are electrically connected in series by means of wire bonding 176.

As shown in Fig. 16, the LED device 156 further comprises a thermal conductive cooling and supporting sheet 178 with an upper outer surface 180 and a lower outer surface 182.

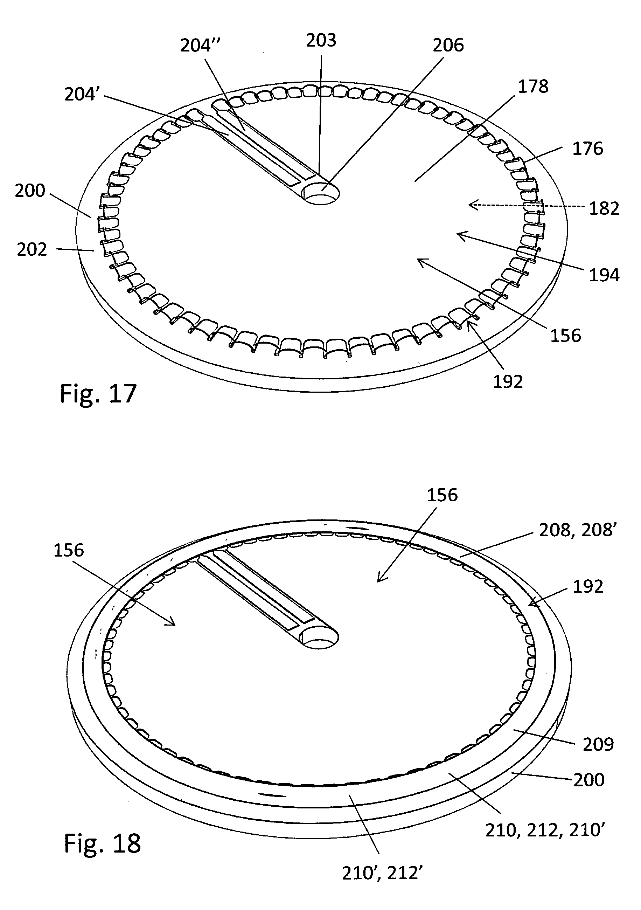

The cooling and supporting sheet 178 has a circular shape as can be seen from Fig. 17.

A number of tongue-like elements 184 are arranged along an outer edge 186 of the cooling and supporting sheet 178, spaced apart from each other and formed integrally with and protruding from the cooling and supporting sheet 178.

Each of the tongue-like elements 184 defines a longitudinal axis 188 and comprises a free end region 190. The LED dies 158 being connected with its bottom surfaces 162 to the free end region 190 of the tongue-like elements 184.

The free end regions 190 of the tongue-like elements 184 supporting the LED dies 158 building up a heat zone 192 and the cooling and supporting sheet 178 building up a cooling-down zone 194.

Each of the LED dies 158 comprises or is made of a thermal conductive material for transporting the heat generated by the LED dies 158 from the bottom surface 162 to an adhesive or glue (not shown) and from there to the upper outer surface 180 of the tongue-like elements 184. The LED dies 158 are preferably made of sapphire.

Each of the LED dies 158 is exclusively mechanically carried by one respective tongue-like element 184.

Preferably, the thickness of each of the tongue-like elements 184 and the cooling and supporting sheet 178 is between about 70 µm and about 200 µm, preferably about 100 µm and the width 198 of each of the tongue-like elements 184 is between about 400 µm and about 1000 µm, preferably about 700 µm.

In addition, preferably the distance between two adjacent tongue-like elements 184 is between 1.3 mm and about 1.7 mm, more preferably about 1.5 mm.

The LED dies 158 being arranged in the free end region 190 of the tongue-like elements 184 on the upper outer surface 180 of the tongue-like elements 184 and close to an end face 196, whereby the width 198 of the tongue-like elements 184, measured parallel to the upper outer surface 180 and orthogonally to the longitudinal axis 188, has at most the same dimension as the LED dies 158 measured in the same direction.

The LED device 156 of the second embodiment with regard to the first aspect mentioned in the introduction part of this application has at least two beneficial effects:

This LED device 156 comprises an improved light distribution due to the setup of the LED dies 158 with respect to the tongue-like elements 184 in the heat zone 192. In addition this LED device 156 comprises an improved cooling effect for the LED dies 158 by an optimized heat transfer from the LED dies 158 in the heat zone 192 to the cooling and supporting sheet 178 as part of the cooling-down zone 194.

As mentioned in the introduction part of this application the light emitted by the LED dies 158 radiates in an angle of 120° out from the surfaces 160, 162, 164, 166, 168 and 170 of the LED dies 158. For this LED device 156 according to the second embodiment of the present invention the light which radiates from the LED dies 158 is blocked in the upward direction to the top surface 160 of the LED dies 158 by the respective two contact pads 172, 174, in the downward direction to the bottom surface 162 of the LED dies 158 by the tongue-like elements 184 and in the lateral downward direction from the rear-side surface 170 of the LED dies 158 also by the tongue-like elements 184. Thus the front-side surface 168, the left-side surface 164 and the right-side surface 166 of the LED dies 158 as well as an exposed region 199 of the top surface 160 beside the respective two contact pads 172, 174 is exposed for the light radiation with the positive effect of an improved light distribution and a corresponding homogenous lightning effect for this LED device 156.

Due to the thermal properties of the tongue-like elements 184 and the cooling and supporting sheet 178 the heat is transferred from the LED dies 158, which are arranged on the upper outer surface 180 of the tongue-like elements 184 in the heat zone 192, to the cooling and supporting sheet 178 in the cooling-down zone 194. Therefore, an optimized heat distribution for this LED device 156 is possible with the beneficial effect of an improved life time corresponding with a deceleration of the material aging.

Fig. 17 schematically shows the LED device 156 of Fig. 16 being attached on a top surface 202 of a single circular-shaped carrier substrate 200, whereby the lower outer surface 182 of the cooling and supporting sheet 178 and tongue-like elements 184 are supported at least almost area-wide by the single circular-shaped carrier substrate 200.

The single carrier substrate 200 is planar, comprises or is made of a transparent or translucent material and comprises or is made of thermal conductive and electrical insulating properties.

The thermal conductivity of the single circular-shaped carrier substrate 200 assists the cooling effect of the LED dies 158, because the heat is not only transferred from the LED dies 158 in the heat zone 192 to the cooling-down zone 194 rather that additionally the heat is transferred in the downward direction to the single circular-shaped carrier substrate 200. Therefore, by this embodiment the heat distribution is well optimized and results in an improved life time with a reduced material aging of the LED dies 158.

As can be seen in Fig. 17 the cooling and supporting sheet 178 comprises a U-shaped recess 203 which extends from the radial outer side radial inwards up to a central hole 206 of the cooling and supporting sheet 178. In the U-shaped recess 203 are arranged a first electrical sheet 204' and a further electrical sheet 204" which are electrical insulated to each other and with respect to the cooling and supporting sheet 178 and the adjacent tongue-like elements 184.

The number of LED dies 158 are electrically connected to each other by wire bonding 176 as shown in Fig. 16, whereby the first LED die 158' is connected to the first electrical sheet 204' and the last LED die 158" is electrically connected to the further electrical sheet 204" by wire bonding 176.

The first electrical sheet 204 and the last electrical sheet 204" are the electrical terminals for a voltage generator (not shown) to supply electrical current through the respective LED dies 158 in series. The voltage generator is preferably arranged close to the central hole 206 at the bottom of the embodiment shown in Fig. 17. The first electrical sheet 204' and the further electrical sheet 204" extend radial inwards close to the central hole 206 for the electrical connection with the voltage generator.

The single circular-shaped carrier substrate 200 comprises or is made of transparent or translucent material to allow that part of the light, emitted from the LED dies 158, which radiates in the lateral downward direction beside the respective tongue-like elements 184, travelling through the material for an improved lightning effect of the LED device 156.

Fig. 18 schematically shows the embodiment of Fig. 17 with a ring shaped encapsulation material 208, preferably a silicone ring 208', being surround the LED dies 158 in the heat zone 192.

In a preferred embodiment of Fig. 18, either, a number of light converting materials 210, preferably a number of phosphor particles 212 are embedded in a matrix of the silicone ring 208' or a layer of the light converting material 210', preferably a phosphor layer 212', is coated on an outer side 209 of the silicone ring 208' to convert the wavelength of the light, which emits from the LED dies 158, into different wavelengths for different colors of light.

To build up a final LED bulb similar to that one shown in Fig. 15 comprising the LED device 156 shown in Fig. 16 to Fig. 18 the method steps as described in connection with Fig. 12 to Fig. 15 can be executed. Consequently the embodiment of Fig. 18 is supported by the bottom housing 126 and covered by the top housing 128 similar to the setup as shown in Fig. 12.

To increase the cooling effect for the LED dies 158 the bottom surface 214 of the single circular-shaped carrier substrate 200 is thermal connected to the inner heat sink 140 which is inserted in the interior 144 of the bottom housing 126 in the same way as shown in Fig. 14.

In the following a third embodiment of a LED device with regard to the second aspect of the present invention mentioned in the introduction part of this application is presented. For the same elements as described and used in connection with the first embodiment of Fig. 1 (LED device 10) and Fig. 10 (LED device 10*) as well as the second embodiment of Fig. 16 (LED device 156) we use the same wording with new reference numerals.

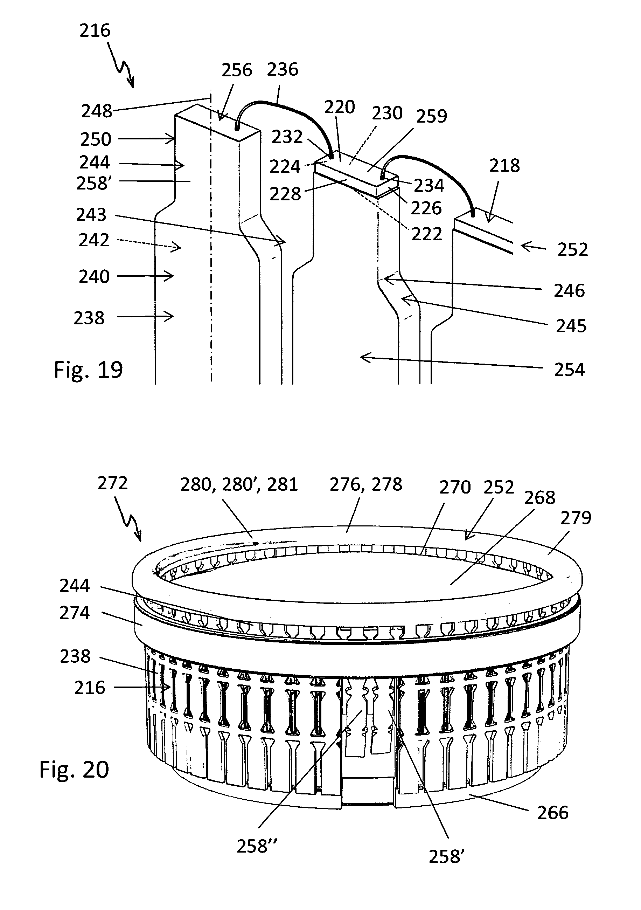

Fig. 19 schematically shows an enlarged view of the third embodiment of a Light Emitting Diode (LED) device 216 according to the present invention.

The LED device 216 comprises a number of LED dies 218 with a top surface 220, a bottom surface 222, a left-side surface 224, a right-side surface 226, a front-side surface 228 and a rear-side surface 230.

Each of the LED dies 218 has, as well known, a number of LED material layers of a P-type semiconductor material, a N-type semiconductor material and an active layer between the P-type semiconductor material and the N-type semiconductor material.

In addition each of the LED dies 218 comprises or is made of translucent or transparent material to allow light emitted from the LED dies 218 to travel through the translucent or transparent material in at least almost all directions to the respective surfaces 220, 222, 224, 226, 228 and 230 of the LED dies 218.

Two contact pads 232, 234 are formed on the top surface 220 of each of the LED dies 218 and spaced apart from each other. The LED dies 218 are electrically connected in series by means of wire bonding 236.

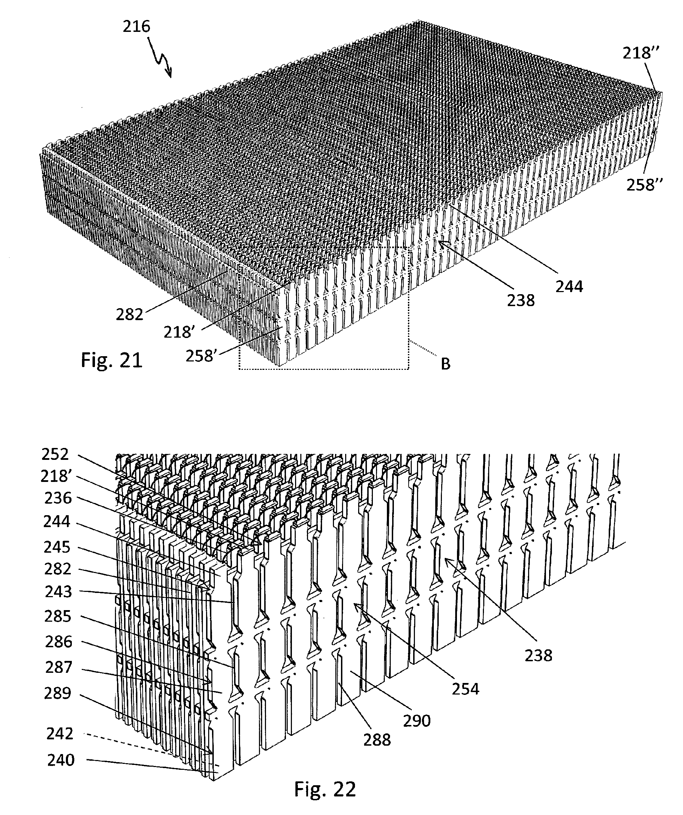

The LED device 216 further comprises a thermal conductive cooling and supporting sheet 238 comprising an upper outer surface 240 and a lower outer surface 242. The cooling and supporting sheet 238 has - in an unwrapped state - an at least almost rectangular shape as shown in Fig. 21 and Fig. 22.

As shown in Fig. 19 the cooling and supporting sheet 238 comprise funnel-shaped slot 243 in an upper end region 245 of the cooling and supporting sheet 238 and along an outer edge 246 of the cooling and supporting sheet 238 being arranged a number of tongue-like elements 244, spaced apart from each other and formed integrally with and protruding from the cooling and supporting sheet 238.

Each of the tongue-like elements 244 defining a longitudinal axis 248 and comprises a free end region 250 with an end face 256. The LED dies 218 being connected with its bottom surfaces 222 to the end face 256 of the tongue-like elements 244, whereby the dimension of the end face 256 has at most the same dimension as the bottom surface 222 of the respective LED dies 218.

Each of the LED dies 218 comprises or is made of a thermal conductive material, preferably sapphire, for transporting the heat generated by the LED dies 218 from the bottom surface 222 directly to the tongue-like elements 238.

The free end regions 250 of the tongue-like elements 244 supporting the LED dies 218 building up a heat zone 252 and the cooling and supporting sheet 238 building up a cooling-down zone 254.

Each of the LED dies 218 is exclusively mechanically carried by one respective tongue-like element 244.

Preferably, the width of each of the tongue-like elements 244 is between about 640 µm and about 680 µm, more preferably about 660 µm and the thickness of each of the tongue-like elements 244 is between about 240 µm and about 280 µm, more preferably about 260 µm, so that the dimension of the end face 256 has at most the same dimension as the bottom surface 222 of the respective LED dies 218.

In addition, preferably the distance between two adjacent tongue-like elements 244 is at most the same distance as the length of the LED dies 218, which is preferably between about 640 µm and about 680 µm, more preferably about 660 µm. Thus the length of the wire bonds 236 is between about 660 µm and about 740 µm, more preferably about 700 µm.

The thermal conductivity of the LED dies 218, an adhesive or glue between the bottom surface 222 of the LED dies 218 and the end face 256 of the tongue-like elements 244, the tongue-like elements 244 itself and the cooling and supporting sheet 238 allows an optimized heat transfer from the LED dies 218 in the heat zone 252 to the cooling-down zone 254. This has an improved cooling effect for the LED dies 218. Therefore, the LED device 216 has a well optimized heat distribution with the beneficial effect of an increased life time corresponding with a deceleration of the material aging.

As can be seen from Fig. 19 the number of LED dies 218 are electrically connected in series by wire bonding 236, whereby a first electrical sheet 258" is wire bonded to the first LED die 218' and a further electrical sheet 258" is wire bonded to the last LED die 218" (see Fig. 21). The first electrical sheet 258' and the further electrical sheet 258" (see Fig. 20) are used as electrical terminals being connected with a voltage generator (not shown) to supply electrical current through the respective LED dies 218 in series.

The LED device 216 of the third embodiment with regard to the first aspect mentioned in the introduction part of this application has at least two beneficial effects:

This LED device 216 comprises an improved light distribution due to the setup of the LED dies 218 with respect to the tongue-like elements 244 in the heat zone 252. In addition this LED device 216 comprises an improved cooling effect for the LED dies 218 by an optimized heat transfer from the LED dies 218 in the heat zone 252 to the cooling and supporting sheet 238 as part of the cooling-down zone 254.

As mentioned in the introduction part of this application the light emitted by the LED die 218 radiates in an angle of 120° out from the outer surfaces 220, 222, 224, 226, 228 and 230 of the LED die 218. For this LED device 216 according to the third embodiment of the present invention the light which radiates from the LED dies 218 is blocked in the upward direction to the top surface 220 of the LED dies 218 by the respective two contact pads 232, 234 and in the downward direction to the bottom surface 222 of the LED dies 218 also by the tongue-like elements 244. Thus the front-side surface 228, the left-side surface 224, the rear-side surface 230 and the right-side surface 226 of the LED dies 218 as well as an exposed region 259 on the top surface 220 beside the respective two contact pads 232, 234 is exposed for the light radiation with the result of an improved light distribution and a corresponding homogeneous lightning effect for this LED device 216.

Due to the thermal properties of the tongue-like element 244 and the cooling and supporting sheet 238 the heat is transferred from the LED dies 218, which are arranged on the end face 256 of the tongue-like elements 244, in the heat zone 252 to the cooling and supporting sheet 238 in the cooling-down zone 254 with the result of an optimized heat distribution for the LED device 216. Therefore the LED device 216 has the beneficial effect of an increased life time corresponding with a deceleration of the material aging.

Fig. 20 schematically shows a crown-like arrangement 272 comprising - in a wrapped state - the LED device 216 according to the third embodiment of the present invention.

The LED device 216 shown in Fig. 19 is - in an unwrapped state - at least almost rectangular-shaped and - in the wrapped state - the LED device 216 is arranged with its cooling and supporting sheet 238 on a lateral surface 266 of a drum-like carrier element 268. The tongue-like elements 244 protrude from an upper end 270 of the drum-like carrier element 268 and build up the crown-like arrangement 272.

Preferably the drum-like carrier element 268 comprises or is made of non-electrical properties.

The wrapped cooling and supporting sheet 238 is held by a clamping ring 274 and the lateral surface 266 of the drum-like carrier element 268. The clamping ring 274 is surrounding the cooling and supporting sheet 238 in the upper end 270 of the drum-like element 268.

The first electrical sheet 258' and the further electrical sheet 258" are electrically disconnected from the cooling and supporting sheet 238 as can be seen in Fig. 20.

The LED dies 218 are surrounded by an encapsulation material 276, preferably a silicone ring 278, which is arranged in the heat zone 252.

In a preferred embodiment of Fig. 20, either, a number of light converting materials 280, preferably a number of phosphor particles 280' are embedded in a matrix of the silicone ring 278 or a layer of a light converting material 281, preferably a phosphor layer 281', is coated on an outer side 279 of the silicone ring 278 to convert the wavelength of the light, which emits from the LED dies 218, into different wavelengths for different colors of light.

The detailed method steps for fabrication of the crown-like arrangement 272 comprising the LED device 216 according to the third embodiment of the present invention is explained in the following by means of the Fig. 21 to Fig. 27.

Fig. 21 and Fig. 22, there is schematically shown a first method step of providing - in an unwrapped state - a number of essentially rectangular-shaped cooling and supporting sheets 238 being arranged in parallel to each other in a pile, whereby each of them are separated by a number of separation plates 282. The separation plates 282 are of smaller size than the number of essentially rectangular-shaped cooling and supporting sheets 238.

In a further method step each tongue-like element 244 is provided with the adhesive or glue and then with the respective LED dies 218 on the end faces 256 of the respective tongue-like elements 244. the first electrical sheet 258' and the further electrical sheet 258" are free from the LED die 218. By this kind of setup of the number of essentially rectangular-shaped cooling and supporting sheets 238 in parallel as shown in Fig. 21 and Fig. 22 allows an easy way to attach each of the respective LED dies 218 on the end face 256 of the respective cooling and supporting sheets 238 by means of a glue technology and to electrically connect the respective LED dies 218 in series and the respective LED dies 218', 218" adjacent to the first electrical sheet 258' and further electrical sheet 258" by means of wire bonding 236 (see Fig. 19).

Fig. 22 schematically shows an enlarged section B of Fig. 21 with the number of thermal conductive cooling and supporting sheets 238 in parallel comprising the upper outer surface 240 and the lower outer surface 242. The cooling and supporting sheet 238 has essentially the rectangular shape in the unwrapped state.

As shown in Fig. 22 the cooling and supporting sheet 238 further comprise a number of longitudinal slots 285 in a middle region 286 to build up a number of middle parts 287 and a number of further longitudinal slots 288 in a lower end region 289 to build up a number of lower end parts 290_of the cooling and supporting sheet 238. The funnel-shaped slots 243 in the upper end region 245, the longitudinal slots 285 in the middle region 286 and the further longitudinal slots 288 in the lower end region 289 of the cooling and supporting sheet 238 are not connected to each other.

The number of tongue-like elements 244 building up the heat zone 252 and the cooling and supporting sheet 238 building up the cooling-down zone 254 and has the function of a heat sink for an improved cooling effect.

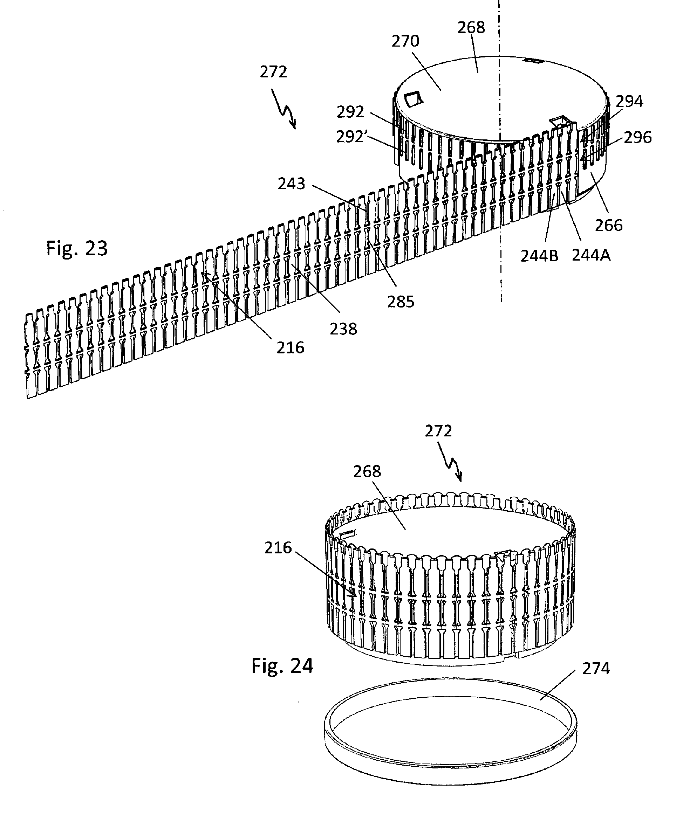

Fig. 23 schematically shows a further method step of wrapping one single cooling and supporting sheet 238 of Fig. 21 around the lateral surface 266 of the drum-like carrier element 268, whereby the tongue-like elements 244 protrude from the upper end 270 of the drum-like carrier element 268 for building up the crown-like arrangement 272.

On the lateral surface 266 of the drum-like carrier element 268 are arranged one row of projections 292 in an upper end region 294 of the drum-like carrier element 268 and a further row of projections 292' in a middle region 296 of the drum-like carrier element 268.

Thus, the funnel-shaped slots 243 of the cooling and supporting sheet 238 engages with the projections 292 of the upper end region 294 of the drum-like carrier element 268 and the longitudinal slots 285 of the cooling and supporting sheet 238 engages with the projections 292' of the middle region 296 of the drum-like carrier element 268 to hold the wrapped cooling and supporting sheet 238 axial and in the circumferential direction in position with respect to the drum-like carrier element 268.

Fig. 24 schematically shows the wrapped state of the LED device 216 in the crown-like arrangement 272 and the clamping ring 274.

The clamping ring 274 comprises or is made of a non-electrical material, preferably polycarbonate.

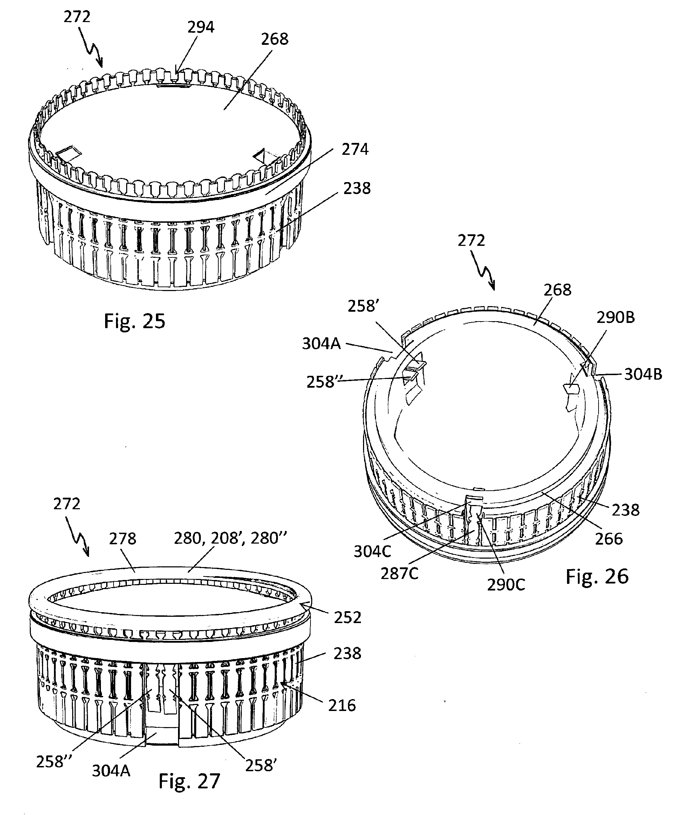

Fig. 25 schematically shows a further method step of pushing the clamping ring 274 from below of the crown-like arrangement 272 to the upper end region 294 of the drum-like carrier element 268 to hold together with the wrapped cooling and supporting sheet 238 the crown-like arrangement 272 in position.

Fig. 26 is schematically shown a further method step of tilting the crown-like arrangement 272 by 180° in order to disconnect the first electrical sheet 258' and the further electrical sheet 258" from the cooling and supporting sheet 238.

The lateral surface 266 of the drum-like carrier element 268 comprises three longitudinal slots 304A, 304B, 304C, which are arranged in the lateral surface 266 in an angle of 120° with respect to the longitudinal axis 269 of the drum-like carrier element 268.

As can be seen from Fig. 27, the first electrical sheet 258' and the further electrical sheet 258" is bended inside the drum-like carrier element 268 through the respective slot 304A. Furthermore, two further middle parts 287B, 287C and lower end parts 290B, 290C being arranged to the respective longitudinal slots 304B, 304C and being bended inside the drum-like carrier element 268. This setup assists the holding position of the wrapped cooling and supporting sheet 238 in the longitudinal direction with respect to the drum-like carrier element 268.

In a further method step, inside the drum-like carrier element 268 a voltage generator (not shown) can be arranged for the electrical supply of the number of LED dies 218 in series, whereby the first electrical sheet 258' and the further electrical sheet 258" can be connected with voltage generator.

Fig. 27 is schematically shown a further method step of covering the number of LED dies 218 in the heat zone 252 by a silicone ring 278 for protecting the LED dies 218 from the surrounding and for cooling the LED dies 218.

In a further method step, either, the number of phosphor particles 280' are embedded in the matrix of the silicone ring 278 or the phosphor layer 280", is coated on the outer side 279 of the silicone ring 278 to convert the wavelength of the light, which emits from the LED dies 218, into different wavelengths for different colors of light.

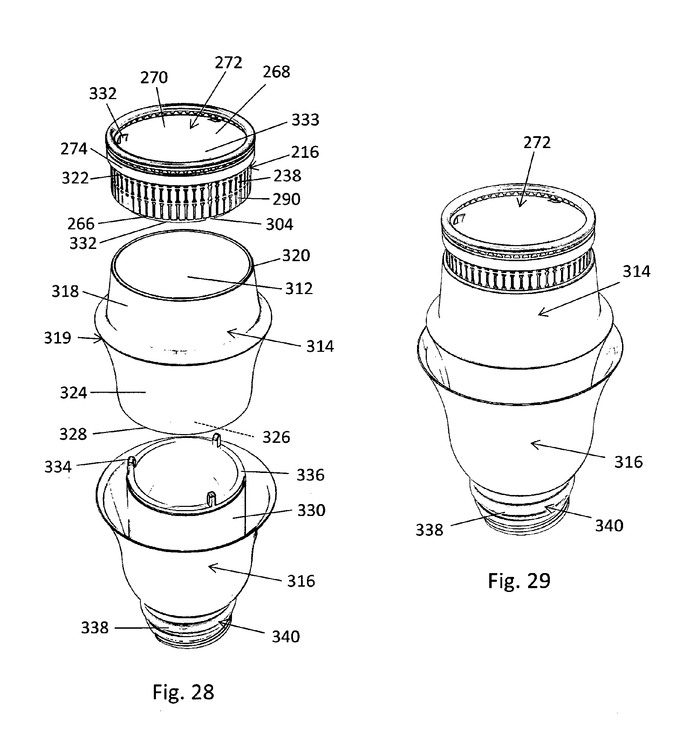

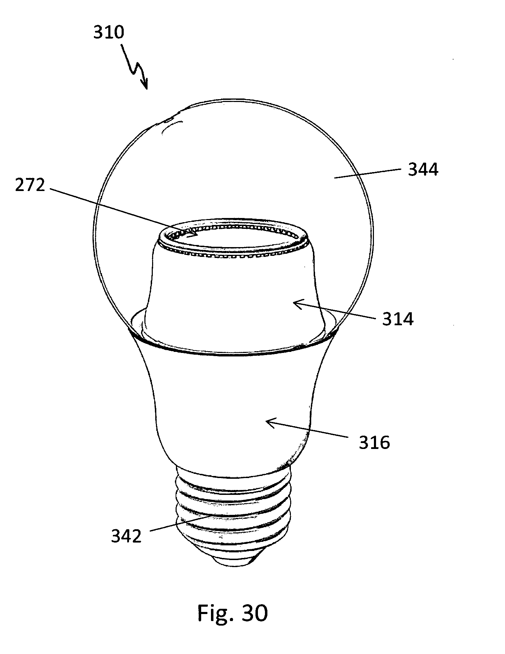

Fig. 28 to Fig. 30, there is schematically shown the setup of a final LED bulb 310 of Fig. 30 with the crown-like arrangement 272 comprising the LED device 216.

Referring to Fig. 28 is shown an exploded view of a setup shown in Fig. 29, whereby the crown-like arrangement 272 comprising the LED device 216 is inserted in an axial through hole 312 of a heat sink 314 and the heat sink 314 is inserted in a socket 316.

The heat sink 314 has an upper part 318 with a shape of a truncated cone whereas the axial through hole 312 in an upper end 320 of the heat sink 314 allows the cooling and supporting sheet 238 to be inserted up to an middle region 319 of the heat sink 314.

A lower part 324 of the heat sink 314 with the shape of a truncated cone and a axial through hole 326 in a lower end 328 of the lower part 324 of the heat sink 314 allows a cylindrical inner part 330 of the socket 316 to be inserted up to the upper end 270 of the drum-like carrier element 268, as shown in Fig. 29 and Fig. 30.

At this state the cylindrical inner part 330 of the socket 316 having three projections 334 protruding from a upper end 336 of the cylindrical inner part 330 corresponding to the slots 332 on the upper surface 333 of the drum-like carrier element 268, so that the three projections 334 are able to engage with the respective slots 332. The projections 334 protruding from the upper end 336 of the cylindrical inner part 330 of the socket 316 allows a protection against rotation of the LED device 216 arranged inside the heat sink 314.

The socket 316 comprises an external thread 338 at a lower end region 340 of the socket 316 for engagement with a plug 342 (see Fig. 30).

Fig. 30 schematically shows the final LED bulb 310 with a cover 344 which protects the crown-like arrangement 272 against the surrounding and the plug 342 is screwed into the external thread 338 of the socket 316 having a standard thread of E27.

The voltage generator (not shown) inside the heat sink 314 is connected on one side with the plug 342 and on the other side with the first electrical sheet 258' and the further electrical sheet 258" for the electrical supply of the LED dies 218 in series.

In the following a fourth embodiment of a LED device with regard to the fourth aspect mentioned in the introduction part of this application is presented. For the same elements as described and used in connection with the first embodiment of Fig. 1 (LED device 10) and Fig. 10 (LED device 10*), the second embodiment of Fig. 16 (LED device 156) and the third embodiment of Fig. 19 (LED device 216) we use the same wording with new reference numerals.

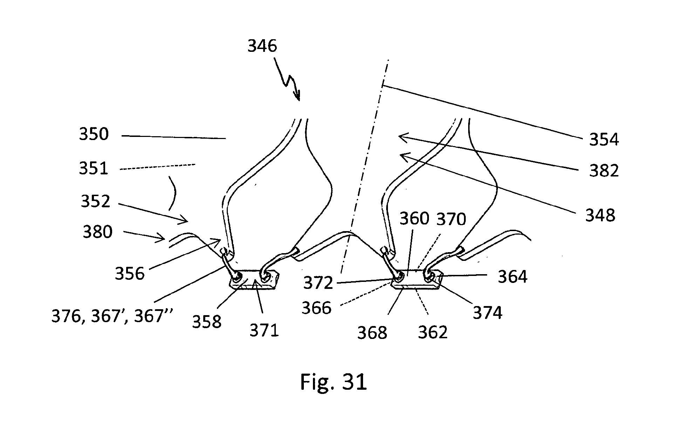

Fig. 31 is schematically shown an enlarged view of the fourth embodiment of a Light Emitting Diode (LED) device 346 according to the present invention.

The LED device 346 comprises a number of electrical and thermal conductive cooling and supporting sheets 348 being spaced apart from each other. Each of the cooling and supporting sheets 348 comprises an upper outer surface 350 and a lower outer surface 351.

Each of the cooling and supporting sheets 348 formed integrally with and protruding from a single tongue-like element 352. Each of the tongue-like elements 352 defining a longitudinal axis 354 and comprises a free end region 356. The tongue-like elements 352 are in a shape of a dovetail.

The LED device 346 further comprises a number of LED dies 358 with a cuboid shape and which has a top surface 360, a bottom surface 362, a right-side surface 364, a left-side surface 366, a front-side surface 368 and a rear-side surface 370.

Each LED die 358 has, as well known, a number of typical LED material layers of a P-type semiconductor material, a N-type semiconductor material and an active layer between the P-type semiconductor material and the N-type semiconductor material.

On the top surface 360 of each of the LED dies 358 are formed two contact pads 372, 374 which are spaced apart from each other. The LED dies 358 being electrically connected in series by means of wire bonding 376.

Each of the LED dies 358 being electrically connected with its two contact pads 372, 374 to the respective upper outer surface 350 of the free end region 356 of two adjacent tongue-like elements 352 by wire-bonding 376.

The free end region 356 of the respective two adjacent tongue-like elements 352 are spaced apart from the respective LED die 358, whereby the LED dies 358 being exclusively mechanically hold by the wire bonds 376 and the free end region 356 of the tongue-like elements 352 builds up a heat zone 380 and the cooling and supporting sheets 348 build up a cooling-down zone 382.

A distance measured from the upper outer surface 350 to the lower outer surface 351 of the cooling and supporting sheets 348 defines its thickness and is between about 70 µm and about 200 µm, preferably about 100 µm in order to have a sufficient mechanical strength to hold the LED dies 358 by wire bonding 376.

Preferably, a length of the wire-bonds 376 is below 1.0 mm and is made of aluminum or gold.

The diameter of wire-bonds 376' made of aluminum is preferably bigger than 30 µm and the wire-bonds 376" made of gold are preferably bigger than 35 µm.

In a preferred embodiment of Fig. 31, the wire-bonds 376" made of gold have a diameter of about 50 µm and a length of about 700 µm.

The electrical power of the LED device 346 according to the fourth embodiment is preferably below 150 mW.

A distance between the respective two adjacent cooling and supporting sheets 348 in the cooling-down zone 382 is smaller than a distance between two adjacent tongue-like elements 352 in the heat zone 380.

A width of each of the cooling and supporting sheets 348 is greater than a width of each of the tongue-like elements 352 measured orthogonally to the longitudinal axis 354 and parallel to the upper outer surface 350 and the lower outer surface 351.

To supply electrical current through the number of LED dies 358 a first cooling and supporting sheet 348' and a last cooling and supporting sheet 348" of the number of cooling and supporting sheets 348 are used as electrical terminals for electrical connection with a voltage generator (not shown). The number of LED dies 358 being electrically connected in series via the respective wire bonds 376.

This LED device 346 comprises an improved light distribution due to the setup of the respective LED die 358 with respect to two adjacent tongue-like elements 352 in the heat zone 380. In addition this LED device 346 comprises an improved cooling effect for the LED dies 358 by an optimized heat transfer from the LED dies 358 in the heat zone 380 to the two adjacent cooling and supporting sheets 348 as part of the cooling-down zone 382.

As mentioned in the introduction part of this application the light emitted by the LED dies 358 radiates in an angle of 120° out from the surfaces 360, 362, 364, 366, 368 and 370 of the LED dies 358. For this LED device 346 according to the fourth embodiment of the present invention the light which radiates from the LED dies 358 is blocked in the upward direction to the top surface 360 of the LED dies 358 by the respective two contact pads 372, 374. Thus, the bottom surface 362, the left-side surface 366, the right-side surface 364, the front-side surface 368, the rear-side surface 370 as well as an exposed region 371 on the top surface 360 beside the respective two contact pads 372, 374 are exposed for an about 360° light distribution with the positive effect of an improved light distribution and a corresponding homogenous lightning effect for this LED device 346 similar to conventional light bulbs.

Due to the thermal properties of the two respective wire-bonds 376, the two adjacent tongue-like elements 352 and the two adjacent cooling and supporting sheets 348 the heat transfer from the respective LED dies 358 along the respective two wire-bonds 376 to the two adjacent tongue-like elements 352 in the heat zone 380 and from there to the two adjacent cooling and supporting sheets 348 as part of the cooling-down zone 382 is optimized. Therefore, an optimized heat distribution for this LED device 346 is possible with the beneficial effect of an increased life time corresponding with a deceleration of the material aging.

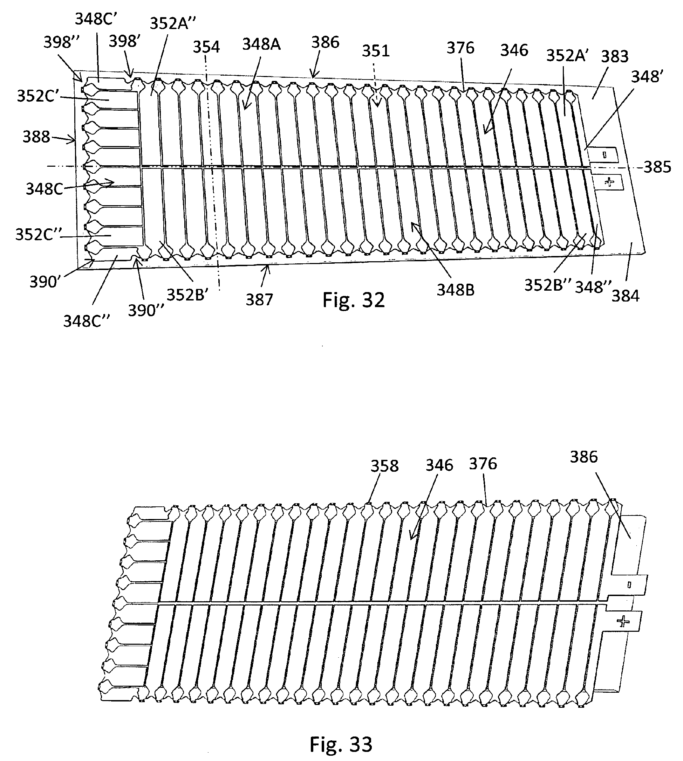

Fig. 32 schematically shows three rows of a number of cooling and supporting sheets 348A, 348B, 348C as parts of the LED device 346 shown in Fig. 30 being attached on a top surface 383 of a single rectangular-shaped carrier substrate 384, whereby the lower outer surfaces 351 of the cooling and supporting sheets 348 and the tongue-like elements 352 are supported at least almost area-wide by the single rectangular-shaped carrier substrate 384. The single rectangular-shaped carrier substrate 384 comprises a longitudinal axis 385.

The first row of cooling and supporting sheets 348A comprises a first electrical sheet 348' being arranged close to a long side 386 of the single rectangular-shaped carrier substrate 384, whereby the longitudinal axis 354 of the tongue-like elements 352 of the first row is orthogonal to the longitudinal axis 385 of the single rectangular-shaped carrier substrate 384.

The second row of cooling and supporting sheets 348B comprises a further electrical sheet 348" being arranged close to the opposite long side 387 of the single rectangular-shaped carrier substrate 384, whereby the longitudinal axis 354 of the first row and second row is identical and orthogonal to the longitudinal axis 386 of the single rectangular-shaped carrier substrate 384.

The third row of cooling and supporting sheets 348C comprises a first intermediate sheet 348C' and a further intermediate sheet 348C" being arranged close to the short side 388 of the single rectangular-shaped carrier substrate 384 orthogonal to the first row of cooling and supporting sheets 348A and the second row of cooling and supporting sheets 384B.

The first intermediate sheet 348C' is arranged close to the long side 385 of the single rectangular-shaped carrier substrate 384 and the further intermediate sheet 348C" is arranged close to the opposite long side 387 of the single rectangular-shaped carrier substrate 384.

As shown in Fig. 32, to supply electrical current through all LED dies 358 in series, the first electrical sheet 348' is connected on one side with a voltage generator (not shown) and on the other side with the first tongue-like element 352A' of the first row by wire bonding 376. The number of LED dies 358 of the first row being electrically connected as shown in Fig. 31. The first intermediate sheet 348C' is connected on one end 389' with the last tongue-like element 352A" of the first row and on the other end 389" with the first tongue-like element 352C' of the third row C by wire bonding 376. The number of LED dies 358 of the third row C is electrical connected as shown in Fig. 31. The further intermediate sheet 348C" is connected on one end 390' with the last tongue-like element 352C" of the third row C and on the other end 390" with the first tongue-like element 352B' of the second row B by wire bonding 376. The number of LED dies 358 of the second row B is electrical connected as shown in Fig. 31. The further electrical sheet 348" is connected on one side with a voltage generator (not shown) and on the other side with the last tongue-like element 352B" of the second row by wire bonding 376.

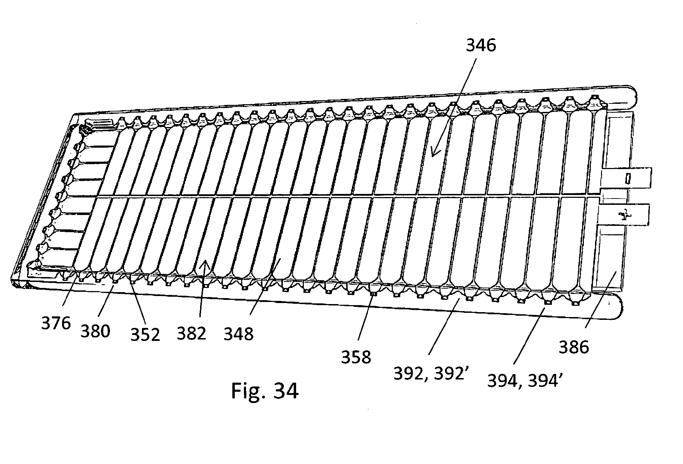

The electrical connection described in connection with Fig. 32 is identical to that one shown in Fig. 33 and Fig. 34.

In the present embodiment the single carrier substrate 384 is planar and comprises or is made of a transparent or translucent material and comprises or is made of thermal conductive and electrical insulating properties.

Preferably, the single carrier substrate 384 made of transparent material is glass with a thermal conductivity less or equal than 10 W/mK.

Possibly, in a further embodiment, not shown in Fig. 32, the LED dies 358 can be held by the respective wire-bonds 376 and being attached with the bottom surface 362 of the LED dies 358 to the top surface 383 of the single carrier substrate 384.

Fig. 33 schematically shows a modified embodiment of Fig 32, whereby the only difference is that the single rectangular-shaped carrier substrate 384 is smaller compared to Fig. 32, so that the tongue-like elements 352, the wire-bonds 376 and the LED dies 358 protrude from a modified single carrier substrate 386.

Regarding the embodiment of Fig. 33 it is possible to increase the cooling effect of the LED device 346 by a sandwich arrangement 103 as shown in Fig. 6 comprising a cooling element 100 and a further cooling element 102 or by a setup as shown in Fig. 9 comprising a cooling element 100 and a comb-shaped heat sink 114.

Fig. 34 schematically shows the embodiment of Fig. 33, whereby the tongue-like elements 352, the wire bonds 376 and the LED dies 358 are surrounded by an encapsulation material 392, preferably silicone 392'.

In a preferred embodiment of Fig. 34, a number of light converting materials 394, preferably a number of phosphor particles 394' are embedded in a matrix of the silicone 392' to convert the wavelength of the light, which emits from the LED dies 358, into different wavelengths for different colors of light.

## Claims

1. Light emitting diode (LED) device comprising:
a number of LED dies (158; 218) with a top surface (160; 220), a bottom surface (162; 222), a left-side surface (164; 224), a right-side surface (166; 226), a front-side surface (168; 228) and a rear-side surface (170; 230), two contact pads (172, 174; 232, 234) formed on the top surface (160; 220) of each LED die and spaced apart from each other, and the LED dies (158; 218) being electrically connected in series by means of wire bonding (176; 236);
a thermal conductive cooling and supporting sheet (178; 238) comprising an upper outer surface (180; 240) and a lower outer surface (182; 242), a number of tongue-like elements (184; 244) arranged along an edge (186; 246) of the cooling and supporting sheet (178; 238), spaced apart from each other, formed integrally with and protruding from the cooling and supporting sheet (178; 238), each of the tongue-like elements (184; 244) defining a longitudinal axis (188; 248) and comprising a free end region (190; 250);
the LED dies (158; 218) being connected with its bottom surfaces (162; 222) to the free end region (190; 250) of the tongue-like elements (184; 244);
the free end regions (190; 250) of the tongue-like elements (184; 244) supporting the LED dies (158; 218) building up a heat zone (192; 252) and the cooling and supporting sheet (178; 238) building up a cooling-down zone (194; 254); whereby
the LED dies (158; 218) being arranged in the free end region (190; 250) of the tongue-like elements (184; 244) either on the upper outer surface (180) of the tongue-like elements (184) or on an end face (256) of the tongue-like elements (184; 244) arranged at least almost orthogonally to the longitudinal axis (188; 248) of the respective tongue-like element (184; 244);
in case the LED dies (158) being arranged on the upper outer surface (180) of the tongue-like elements (184), the LED dies (158) being arranged close to the end face (196) and the width (198) of the tongue-like elements (184), measured parallel to the upper outer surface (180) and orthogonally to the longitudinal axis (188), has at most the same dimension as the LED dies (158) measured in the same direction; and
in case the LED dies (218) being arranged on the end face (256) of the tongue-like elements (244), the dimension of the end face (256) has at most the same dimension as the bottom surface (222) of the respective LED die (218).

2. A Light emitting diode (LED) device comprising:
a number of LED dies (24) with a top surface (46), a bottom surface (48), a left-side surface (52), a right-side surface (50), a front-side surface (54) and a rear-side surface (56), and two contact pads (26, 28) formed on the bottom surface (48) of each LED die (24) and spaced apart from each other;
a number of electrical and thermal conductive cooling and supporting sheets (12) spaced apart from each other, comprising an upper outer surface (14) and a lower outer surface (16), each of the cooling and supporting sheets (12) formed integrally with and protruding from a single tongue-like element (18), each of the tongue-like elements (18) defining a longitudinal axis (20) and comprising a free end region (22);
each of the LED dies (24) being connected with its two contact pads (26, 28) to the upper outer surface (14) of the free end region (22) of two adjacent tongue-like elements (18) by means of solder bumps (30, 32);
the free end regions (22) of the respective two adjacent tongue-like elements (18) supporting the respective LED die (24), building up a heat zone (36) and the cooling and supporting sheets (12) building up a cooling-down zone (38); and
the respective LED die (24) being arranged close to an end face (40) of the respective two adjacent tongue-like elements (18) and the respective two tongue-like elements (18) at least almost completely covering the two contact pads (26, 28) and being arranged at least almost in a same distance (41) to each other as the contact pads (26, 28).

3. LED device according to claim 2, **characterized in that** one contact pad (26) of the respective LED die (24) is arranged adjacent to the left-side surface (52) and the other contact pad (28) of the respective LED die (24) is arranged adjacent to the right-side surface (50) of the respective LED die (24) and both contact pads (26, 28) extend at least almost from a rear-side end region (72) of the bottom surface (48) adjoining the rear-side surface (56) to a front-side end region (74) of the bottom surface (48) adjoining the front-side surface (54).

4. LED device according to claim 2 or 3, **characterized in that** the free end region (22) of each of the tongue-like elements (18) forming a T-shaped extension (36) which is used for connecting the respective contact pad (26, 28) of two adjacent LED dies (24).

5. LED device according to any of the claims 2 to 4, **characterized in that** A distance (44) between the respective two adjacent cooling and supporting sheets (12) in the cooling-down zone (38) is smaller than the distance (41) between the two contact pads (26, 28) of the respective LED die (24) in the heat zone (36).

6. LED device according to any of the claims 2 to 5, **characterized in that** a width (43) of the cooling and supporting sheets (12) is greater than a width (45) of the tongue-like elements (18) measured orthogonally to the longitudinal axis (20) and parallel to the upper outer surface (14) and lower outer surface (16).

7. LED device according to any of the claims 2 to 6, **characterized in that** a first cooling and supporting sheet (12A) and a last cooling and supporting sheet (12F) of the number of cooling and supporting sheets (12) are used as electrical terminals for electrical connection with a voltage generator to supply electrical current through the number of LED dies (24) are connected in series via the respective tongue-like elements (18).

8. LED device according to any of the claims 1 to 7, **characterized in that** the lower outer surface (14; 180) of the cooling and supporting sheet (178) and cooling and supporting sheets (12), respectively, and the tongue-like elements (18; 184) are supported at least almost area-wide by a single carrier substrate (82; 200), whereby the single carrier substrate (82; 200) is preferably planar with preferably a circular or rectangular shape, preferably comprises a transparent or translucent material and preferably comprises thermal conductive and electrical insulating properties.

9. LED device according to any of the claims 1 to 7, **characterized in that** the lower outer surface (14; 180) of the cooling and supporting sheet (178) and cooling and supporting sheets (12), respectively, is supported at least almost area-wide by a single carrier substrate (96), whereby the single carrier substrate (96) is preferably planar with preferably a circular or rectangular shape, preferably comprises a transparent or translucent material and preferably comprises thermal conductive and electrical insulating properties, and whereby the tongue-like elements (18; 184) protrude the single carrier substrate (96).

10. LED device as claimed in claim 9, **characterized in that** a further single carrier substrate (98) is supported at least almost area-wide by the upper outer surface (14; 180) of the cooling and supporting sheet (178) and cooling and supporting sheets (12), respectively, whereby the further single carrier substrate (98) is preferably planar with preferably a circular or rectangular shape, preferably comprises a transparent or translucent material and preferably comprises thermal conductive and electrical insulating properties.

11. LED device according to claim 10, **characterized in that** a cooling element (100) is supported at least almost area-wide by the single carrier substrate (96), whereby the cooling element (100) is preferably planar with preferably a circular or rectangular shape and is preferably made of cooper, and a further cooling element (98) is supported at least almost area-wide by the further single carrier substrate (98), whereby the further cooling element (102) is preferably planar with preferably a circular or rectangular shape and is preferably made of cooper.

12. LED device as claimed in claim 10, **characterized in that** a cooling element (100) is supported at least almost area-wide by the single carrier substrate, whereby the cooling element (100) is preferably planar with preferably a circular or rectangular shape and is preferably made of cooper, and a comb-shaped heat sink (114) is supported at least almost area-wide by the further single carrier substrate (98), whereby the comb-shaped heat sink (114) preferably comprises a circular or rectangular shape and is preferably made of cooper.

13. LED device according to claim 1, **characterized in that** in case the LED dies (218) being arranged on the end face (256) of the tongue-like elements (244), the single cooling and supporting sheet (238) comprises an at least almost rectangular shape and is arranged on a lateral surface (266) of a drum-like carrier element (268), whereby the tongue-like elements (244) protrude from an upper end (270) of the drum-like carrier element (268) and build up a crown-like arrangement (272).

14. LED device according to claim 13, **characterized in that** the rectangular-shaped cooling and supporting sheet (238) is held by the lateral surface (266) of the drum-like carrier element (268) and a clamping ring (274) surrounding the cooling and supporting sheet (238).

15. LED device according to any of the claims 1 to 14, **characterized in that** the LED dies (24; 158; 218) are mechanically carried exclusively by the tongue-like elements (18; 184; 244).

16. LED device according to any of the claims 1 to 15, **characterized in that** the LED dies (24; 158; 218) comprise a transparent or translucent material to allow light emitted from the LED dies (24; 158; 218) to travel through the translucent material in all directions to the surfaces of the LED dies (24; 158; 218).

17. LED device according to any of the claims 1 to 16, **characterized in that** the LED dies (24; 158; 218) comprise a thermal conductive material, preferably sapphire, for transporting heat generated by the LED dies (24; 158; 218) to the bottom surface (48; 162; 222) of the LED dies (24; 158; 218), from there heat is transferred to the tongue-like elements (18; 184; 244) and from there to the single cooling and supporting sheet (178; 238) and cooling and supporting sheets (12), respectively.

18. LED device according to any of the claims 1 to 17, **characterized in that** the LED dies are surrounded by an encapsulation material (90; 208; 276; 392), preferably silicone (90'; 208'; 278; 392'), whereby the encapsulation material (90; 208; 276; 392) comprises a light converting material (92; 210; 280; 394), preferably a number of phosphor particles (92'; 212; 280'; 394'), or is coated on an outer side (104; 209; 279) with the light converting material (92, 94; 210, 210'; 280, 281) or is coated on the outer side (104) with a glass material (106) which is coated on an outer side (108) or an inner side (110) with the light converting material (92, 94).

19. A Light emitting diode (LED) device comprising:
a number of LED dies (358) with a top surface (360), a bottom surface (362), a left-side surface (366), a right-side surface (364), a front-side surface (368) and a rear-side surface (370), two contact pads (372, 374) formed on the top surface (360) of each LED die (358) and spaced apart from each other, and the LED dies (358) being electrically connected in series by means of wire bonding (376);
a number of electrical and thermal conductive cooling and supporting sheets (348) spaced apart from each other, comprising an upper outer surface (350) and a lower outer surface (351), each of the cooling and supporting sheets (348) formed integrally with and protruding from a single tongue-like element (352), each of the tongue-like elements (352) defining a longitudinal axis (354) and comprising a free end region (356);
each of the LED dies (358) being electrically connected with its two contact pads (372, 374) to the respective upper outer surface (350) of the free end region (356) of two adjacent tongue-like elements (352) by wire bonding (376), the free end regions (356) of the respective two adjacent tongue-like elements (352) being spaced apart from the respective LED die (358); and
the LED dies being (358) mechanically hold by the wire bonds (376) and the free end region (356) of the tongue-like elements (352) builds up a heat zone (380) and the cooling and supporting sheets (348) build up a cooling-down zone (382).
